# EUROPEAN PATENT APPLICATION

(11) **EP 4 661 073 A1**
(43) Date of publication of application: **10.12.2025**
(21) Application number: 25150912.1
(22) Date of filing: 09.01.2025
(51) Int. Cl.: H01L 23/00

(54) **SEMICONDUCTOR CHIP FOR BONDING SEMICONDUCTOR DEVICE, AND BONDING SEMICONDUCTOR DEVICE AND ELECTRONIC SYSTEM INCLUDING THE SAME**

(30) Priority: 04.06.2024 KR 20240073303
(71) Applicant: Samsung Electronics Co., Ltd., Suwon-si, Gyeonggi-do 16677 (KR)
(72) Inventor: HYUN, Seung, 16677 Suwon-si, Gyeonggi-do (KR); KIM, Sungchul, 16677 Suwon-si, Gyeonggi-do (KR); KIM, Cheolgyu, 16677 Suwon-si, Gyeonggi-do (KR); PARK, Jung-Hwan, 16677 Suwon-si, Gyeonggi-do (KR); JUNG, Kwangyoung, 16677 Suwon-si, Gyeonggi-do (KR); CHOI, Yoojin, 16677 Suwon-si, Gyeonggi-do (KR)
(74) Representative: Kuhnen & Wacker Patent- und Rechtsanwaltsbüro PartG mbB

(57) **Abstract**

A semiconductor chip (100, 200) for a bonding semiconductor device (10) includes a substrate (110, 210), a wiring portion (180, 280) on the substrate (110, 210), and a bonding portion (190, 290) on the wiring portion (180, 280). The bonding portion (190, 290) includes an insulation layer (192, 292), a bonding structure (194, 294), and an extension pattern (198, 298). The bonding structure (194, 294) includes a pad structure (195, 295) passing through the insulation layer (192, 292) and a dummy structure (196, 296) passing through a partial portion of the insulation layer (192, 292). The extension pattern (198, 298) is at a lower portion of the dummy structure (196, 296) that is adjacent to the wiring portion (180, 280) and includes an extension portion (198a) extending in one direction in a plan view.

## Description

### BACKGROUND

### (a) Field

The present disclosure relates to semiconductor chips for a bonding semiconductor device, and bonding semiconductor devices and electronic systems including the same. More particularly, the present disclosure relates to semiconductor chips for a bonding semiconductor device that has an enhanced structure, and bonding semiconductor devices that have an enhanced structure and electronic systems including the same.

### (b) Description of the Related Art

In an electronic system implementing a data storage, a semiconductor device capable of storing higher-capacity data is in demand. Accordingly, a method for increasing a data storage capacity of a semiconductor device is being researched. For example, as one method for increasing the data storage capacity of a semiconductor device, a semiconductor device including three-dimensionally arranged memory cells instead of two-dimensionally arranged memory cells has been proposed.

### SUMMARY

The present disclosure attempts to provide semiconductor chips for a bonding semiconductor device that are capable of enhancing reliability and/or productivity, and bonding semiconductor devices being capable of enhancing reliability and/or productivity and electronic systems including the same.

According to an example embodiment, a semiconductor chip for a bonding semiconductor device includes a substrate, a wiring portion on the substrate, and a bonding portion on the wiring portion. The bonding portion includes an insulation layer, a bonding structure, and an extension pattern. The bonding structure includes a pad structure and a dummy structure, the pad structure passing through the insulation layer, the dummy structure passing through a partial portion of the insulation layer. The extension pattern is at a lower portion of the dummy structure, the lower portion of the dummy structure being a portion adjacent to the wiring portion, the extension pattern including an extension portion that extends in one direction in a plan view.

According to an example embodiment, a bonding semiconductor device includes a cell region and a circuit region that are bonded to each other. Each of the cell region and the circuit region includes a bonding portion that includes an insulation layer and a bonding structure, and the bonding structure includes a pad structure and a dummy structure. The cell region includes a gate stacking structure and a channel structure. The gate stacking structure includes a plurality of interlayer insulation layers and a plurality of gate electrodes alternately stacked on each other and extends in a first direction. The channel structure passes through the gate stacking structure. The bonding portion in at least one of the circuit region or the cell region includes an extension pattern, the extension pattern being on a lower portion of the dummy structure and including an extension portion that extends in the first direction.

According to an example embodiment, an electronic system includes a main substrate, a bonding semiconductor device on the main substrate, and a controller on the main substrate and electrically connected to the semiconductor device. The bonding semiconductor device includes a cell region and a circuit region that are bonded to each other. Each of the cell region and the circuit region includes a bonding portion that includes an insulation layer and a bonding structure, and the bonding structure includes a pad structure and a dummy structure. The cell region includes a gate stacking structure and a channel structure. The gate stacking structure includes a plurality of interlayer insulation layers and a plurality of gate electrodes alternately stacked on each other and extends in a first direction. The channel structure passes through the gate stacking structure. The bonding portion in at least one of the circuit region or the cell region includes an extension pattern, the extension pattern being on a lower portion of the dummy structure and including an extension portion, the extension portion extending in the first direction.

According to an example embodiment, by an extension pattern being on a lower portion of a dummy structure, a warpage (e.g., a wafer global warpage and/or a chip warpage) that may occur in a bonding semiconductor device may be reduced or compensated for and an etching process may be controlled in a process of forming the dummy structure. The extension pattern may be formed by a relatively easy manufacturing process. The extension pattern may be disposed at an empty space at the lower portion of the dummy structure and thus may be applied to the bonding semiconductor device without an additional space. By adjusting a material, a volume, a width, a thickness, a shape, a position, an arrangement, or so on of the extension pattern, the warpage of the bonding semiconductor device may be effectively reduced and/or be precisely controlled. Thereby, reliability and/or productivity of the bonding semiconductor device may be enhanced.

### BRIEF DESCRIPTION OF THE DRAWINGS

FIG. 1 is a plan view that schematically illustrates a bonding semiconductor device according to an example embodiment.
FIG. 2 is a partial cross-sectional view that schematically illustrates a bonding semiconductor device according to an example embodiment.
FIG. 3 is an enlarged partial cross-sectional view that illustrates an example of a channel structure included in the bonding semiconductor device illustrated in FIG. 2.
FIG. 4 conceptually illustrates a warpage of a semiconductor substrate according to a shape of a structure disposed on the semiconductor substrate.
FIG. 5 is a partial cross-sectional view that illustrates a partial portion of the bonding semiconductor device illustrated in FIG. 1.
FIG. 6 is a partial cross-sectional view that illustrates a partial portion of the bonding semiconductor device illustrated in FIG. 1.
FIG. 7 is an enlarged plan view of a portion A of FIG. 1.
FIG. 8 is an enlarged plan view of a portion B of FIG. 1.
FIG. 9 conceptually illustrates warpage reduction in a cell region by a first extension pattern included in a cell region and a second extension pattern included in a circuit region in a case that the cell region is a warpage region.
FIG. 10 to FIG. 17 are partial cross-sectional views that illustrate a manufacturing method of a bonding portion included in the bonding semiconductor device illustrated in FIG. 1.
FIG. 18 is a cross-sectional view that illustrates a partial portion of a bonding semiconductor device according to an example embodiment.
FIG. 19 is a cross-sectional view that illustrates a partial portion of a bonding semiconductor device according to an example embodiment.
FIG. 20 is a plan view that illustrates a partial portion of a bonding semiconductor device according to an example embodiment.
FIG. 21 is a plan view that illustrates a partial portion of a bonding semiconductor device according to a modified example embodiment.
FIG. 22 is a plan view that illustrates a partial portion of a bonding semiconductor device according to an example embodiment.
FIG. 23 is a plan view that illustrates a partial portion of a bonding semiconductor device according to an example embodiment.
FIG. 24 is a plan view that illustrates a partial portion of a bonding semiconductor device according to an example embodiment.
FIG. 25 is a plan view that illustrates a partial portion of a bonding semiconductor device according to a modified example embodiment.
FIG. 26 is a plan view that illustrates a partial portion of a bonding semiconductor device according to an example embodiment.
FIG. 27 is a plan view that illustrates a partial portion of a bonding semiconductor device according to an example embodiment.
FIG. 28 schematically illustrates an electronic system that includes a bonding semiconductor device according to an example embodiment.
FIG. 29 is a perspective view that schematically illustrates an electronic system including a bonding semiconductor device according to an example embodiment.
FIG. 30 is a cross-sectional view that schematically illustrates a semiconductor package according to an example embodiment.

### DETAILED DESCRIPTION

Example embodiments of the present disclosure will be described more fully hereinafter with reference to the accompanying drawings for those skilled in the art to which the present disclosure pertains to easily practice the present disclosure. The present disclosure may be implemented in various different forms and is not limited to the example embodiment provided herein.

A portion unrelated to the description is omitted in order to clearly describe the example embodiments of the present disclosure, and the same or similar components are denoted by the same reference numeral throughout the present specification.

Further, since a size and/or a thickness of a portion, a region, a member, a unit, a layer, a film, a substrate, or so on illustrated in the accompanying drawings may be arbitrarily illustrated for better understanding and convenience of explanation, the present disclosure is not limited to the illustrated size and/or thickness. In the drawings, thicknesses of portions, regions, members, units, layers, films, etc. may be enlarged or exaggerated for convenience of explanation and/or simple illustration

It will be understood that when a component such as a portion, a region, a member, a unit, a layer, a film, a substrate, or so on is referred to as being "on" another component, it may be directly on another component or an intervening component may also be present. In contrast, when a component is referred to as being "directly on" another component, there is no intervening component present. Further, when a component is referred to as being "on" or "above" a reference component, a component may be positioned on or below the reference component, and does not necessarily be "on" or "above" the reference component toward an opposite direction of gravity.

In addition, throughout the specification, unless explicitly described to the contrary, the word "comprise", "include", or "contain", and variations such as "comprises", "comprising", "includes", "including", "contains" or "containing" will be understood to imply the inclusion of other components rather than the exclusion of any other components.

Further, throughout the specification, a phrase "on a plane", "in a plane", "on a plan view", or "in a plan view" may indicate a case where a portion is viewed from above or a top portion, and a phrase "on a cross-section" or "in a cross-sectional view" may indicate when a cross-section taken along a vertical direction is viewed from a side.

As used herein, expressions such as "at least one of," when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the term "about," "substantially" or "approximately" is used in this specification in connection with a numerical value, it is intended that the associated numerical value includes a manufacturing or operational tolerance (e.g., ±10%) around the stated numerical value. Moreover, when the word "about," "substantially" or "approximately" is used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

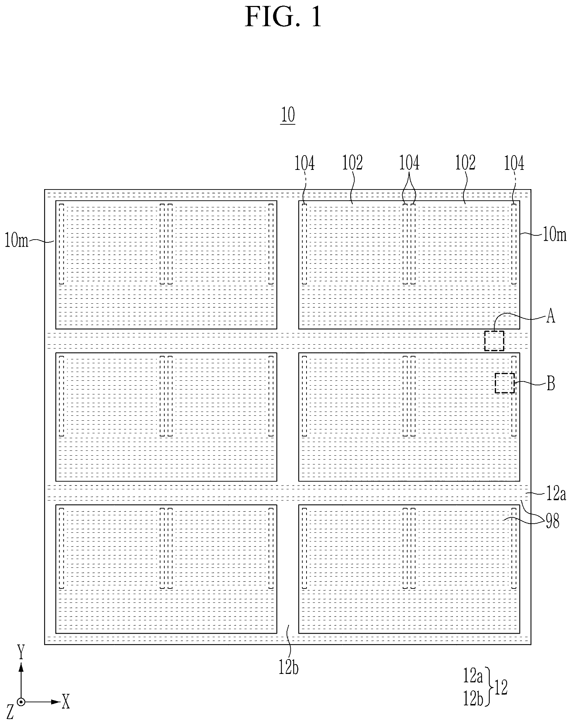

Hereinafter, with reference to FIG. 1 to FIG. 17, a bonding semiconductor device and a semiconductor chip included in the bonding semiconductor device according to some example embodiments will be described in detail.

FIG. 1 is a plan view that schematically illustrates a bonding semiconductor device 10 according to an example embodiment.

Referring to FIG. 1, in an example embodiment, a bonding semiconductor device 10 may include a plurality of memory regions 10m that are divided, partitioned, or defined by a partition portion 12.

The memory region 10m may be a unit region of the bonding semiconductor device 10, and may be referred to as a mat. In FIG. 1, it is illustrated as an example that the bonding semiconductor device 10 includes a plurality of memory regions 10m that are adjacent to each other in a first direction (an X-axis direction in the drawings) and a plurality of memory regions 10m that are adjacent to each other in a second direction (a Y-axis direction in the drawings). However, example embodiments are not limited thereto, and a number, an arrangement, or so on of the plurality of memory regions 10m may be variously modified.

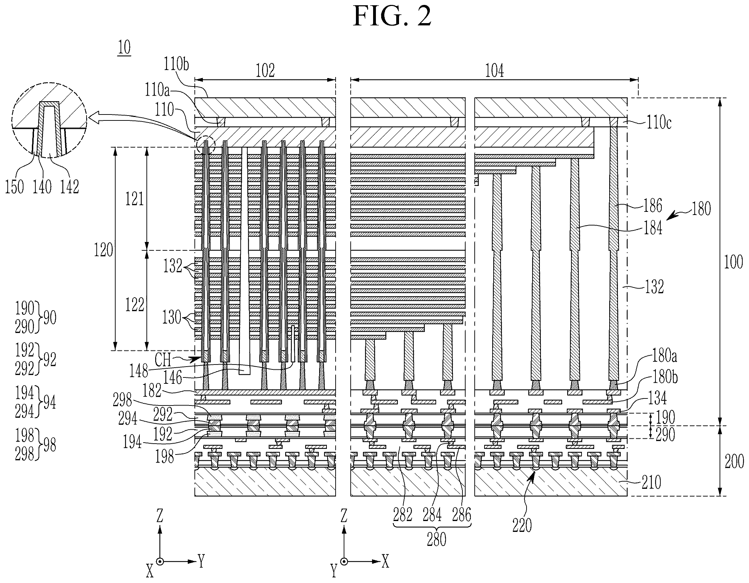

Each memory region 10m or each cell region 100 (refer to FIG. 2) may include a cell array region 102 and a connection region 104. In the cell array region 102, a gate stacking structure 120 (refer to FIG. 2) and a channel structure CH (refer to FIG. 2) are provided. In the connection region 104, a plurality of gate electrodes 130 (refer to FIG. 2) that are included in the gate stacking structure 120 are connected to a plurality of gate contact portions 184 (refer to FIG. 2), respectively. The connection regions 104 are disposed at edge regions of cell array region 102, respectively, in the memory region 10m. In FIG. 1, it is illustrated as an example that the connection regions 104 are disposed at edge regions and an inner region (e.g., a central region) of a respective memory region 10m of the bonding semiconductor device 10 in a first direction (the X-axis direction in the drawings) and the edge regions and the inner region are disposed at the edge regions of cell array regions 102 in the corresponding memory region 10m, respectively. However, example embodiments are not limited thereto. In some example embodiments, in the first direction, the connection region 104 may be disposed at one side of the cell array region 102, or may be disposed at both sides of the cell array region 102 and might not be disposed at an inner region of the cell array region 102. Various modifications are possible.

The partition portion 12 may be provided between the plurality of memory regions 10m to divide, partition, or define the plurality of memory regions 10m. The partition portion 12 may be a portion where the memory region 10m or the gate stacking structure 120 is not disposed. The partition portion 12 may include at least one first partition portion 12a that longitudinally extends in the first direction and at least one second partition portion 12b that longitudinally extends in the second direction. Thereby, a structure of the partition portion 12 may be simplified. However, example embodiments are not limited thereto. The first and/or second partition portion 12a and/or 12b may include a bent portion, a folded portion, a curved portion, a rounded portion, or so on according to an arrangement of the plurality of memory regions 10m.

In an example embodiment, the bonding semiconductor device 10 may be formed by bonding a plurality of regions (e.g., semiconductor chips for a bonding semiconductor device). An extension pattern 98 may be provided in at least a partial portion of the partition portion 12 and/or the memory region 10m. The extension pattern 98 may be configured to reduce or compensate for a warpage issue of the bonding semiconductor device 10 (e.g., a wafer global warpage and/or a chip warpage). For a clear understanding, in FIG. 1, a position and a shape of the extension pattern 98 are schematically illustrated. However, example embodiments are not limited thereto, and a position, a shape, an arrangement, a number, or so on of the extension pattern 98 may be variously modified.

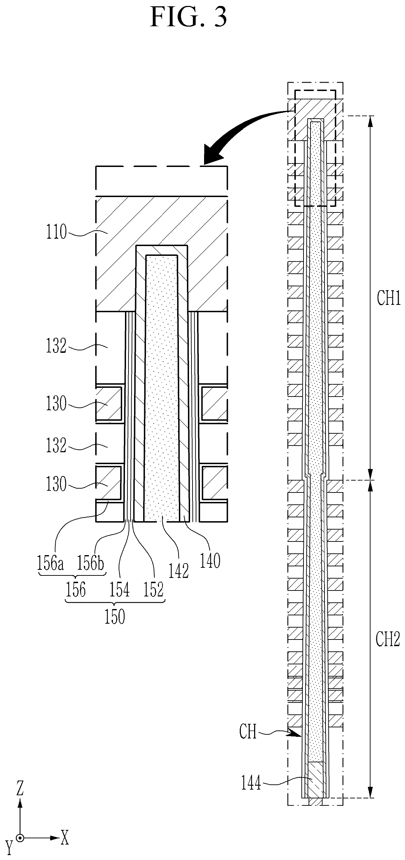

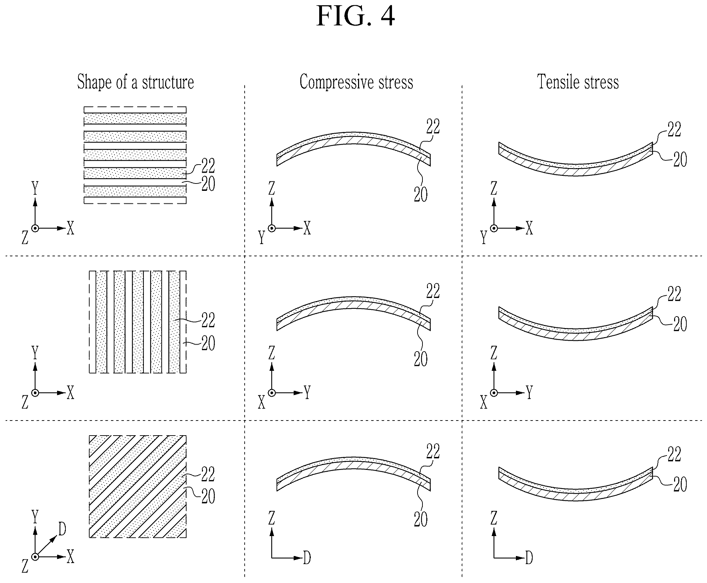

The bonding semiconductor device 10 will be described with reference to FIG. 2 and FIG. 3, and the extension pattern 98 will be described in detail with reference to FIG. 4 to FIG. 9.

FIG. 2 is a partial cross-sectional view that schematically illustrates a bonding semiconductor device 10 according to an example embodiment. FIG. 3 is an enlarged partial cross-sectional view that illustrates an example of a channel structure CH included in the bonding semiconductor device 10 illustrated in FIG. 2. For a clear understanding, a gate contact portion 184 and a source contact portion 186 are illustrated together in FIG. 2, but positions of the gate contact portion 184 and the source contact portion 186 may be variously modified.

Referring to FIG. 2 and FIG. 3, a bonding semiconductor device 10 according to an example embodiment may include a cell region 100 that includes a memory cell structure and a circuit region 200 that includes a peripheral circuit structure configured to control an operation of the memory cell structure. The cell region 100 and the circuit region 200 may be bonded to each other to constitute the bonding semiconductor device 10. The cell region 100 or the circuit region 200 may be a semiconductor chip for a bonding semiconductor device that is included in the bonding semiconductor device 10.

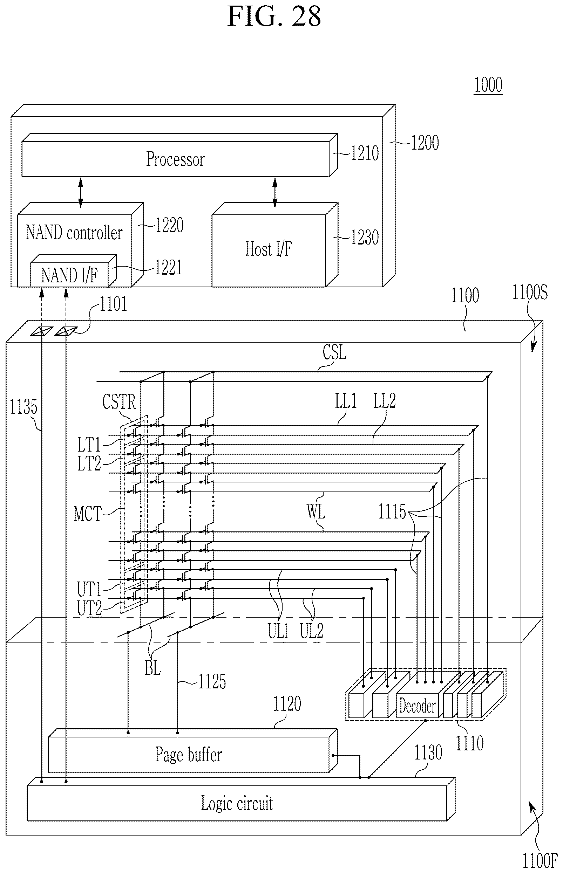

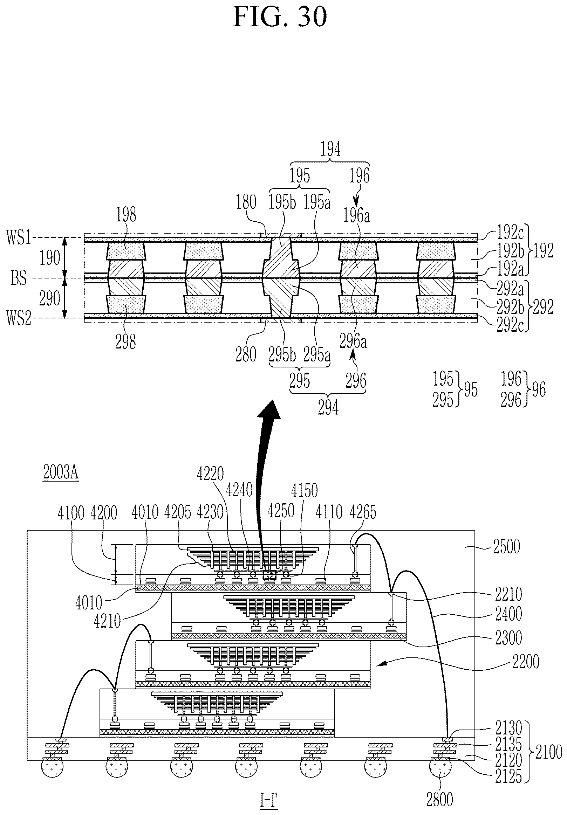

For example, the circuit region 200 and the cell region 100 may correspond to a first structure 1100F and a second structure 1100S of a semiconductor device 1100 that is included in an electronic system 1000 illustrated in FIG. 28, respectively. For example, the circuit region 200 and the cell region 100 may be portions that include a first structure 4100 and a second structure 4200 of a semiconductor chip 2200 illustrated in FIG. 30, respectively. For example, the bonding semiconductor device 10 may be a bonding vertical NAND flash memory or a bonding vertical NAND (BV-NAND).

In an example embodiment, the cell region 100 may be disposed on the circuit region 200. Accordingly, an area corresponding to the circuit region 200 may not desired to be secured separately from the cell region 100. Therefore, an area of the bonding semiconductor device 10 may be reduced.

In an example embodiment, the cell region 100 may be separately manufactured from the circuit region 200 and be bonded to the circuit region 200 to form the bonding semiconductor device 10. For example, the cell region 100 may be bonded to the circuit region 200 by a chip to chip (C2C) bonding process, a chip to wafer bonding process, or a wafer to wafer bonding process that is a hybrid bonding process. By manufacturing the cell region 100 and the circuit region 200 using separate processes, it is possible to mitigate or prevent the circuit region 200 from being adversely affected when the cell region 100 is formed.

The cell region 100 may include a first substrate 110, a gate stacking structure 120, a channel structure CH, a first wiring portion 180, and a first bonding portion 190 that is disposed on the first wiring portion 180. The cell region 100 may be a semiconductor chip for a bonding semiconductor device, the first substrate 110 may be a substrate, the first wiring portion 180 may be a wiring portion that is disposed on the substrate, and the first bonding portion 190 may be a bonding portion that is disposed on the wiring portion.

In an example embodiment, a source connecting portion 110b may be provided at a side of an outer surface of the first substrate 110. The source connecting portion 110b may be connected to the first substrate 110 through a through via 110a that passes through an outer insulation layer 110c. A source contact portion 186 may be connected to the source connecting portion 110b through the through via 110a or be directly connected to the source connecting portion 11 0b. The source connecting portion 110b and/or the through via 110a may include or be formed of a conductive material having an electrical resistance less than an electrical resistance of the first substrate 110. For example, the source connecting portion 110b may include a metal material such as tungsten (W), copper (Cu), aluminum (Al), or so on.

If current flows through the first substrate 110, a voltage drop or noise may occur due to the electrical resistance of the first substrate 110, and thus, an operation (e.g., read operation) of a memory cell might not be performed smoothly. Accordingly, the source connecting portion 110b that is connected to the first substrate 110 and has the electrical resistance less than the electrical resistance of the first substrate 110 is further provided to provide an electrical connection path having a low electrical resistance. The first substrate 110 and/or the source connecting portion 110b may act as a common source line. The source connecting portion 110b may have any of various shapes providing the electrical connection path, and example embodiments are not limited thereto.

The cell region 100 may include a cell array region 102 and a connection region 104. The cell region 100 may include a gate stacking structure 120 and a channel structure CH as the memory cell structure. The gate stacking structure 120 and/or the channel structure CH may be disposed at least in the cell array region 102. A structure that connects the memory cell structure to the circuit region 200 or to an external circuit may be disposed in the cell array region 102 and/or the connection region 104.

In an example embodiment, the first substrate 110 may include a semiconductor layer including a semiconductor material. For example, the first substrate 110 may be a semiconductor substrate that includes or is formed of a semiconductor material or may be a semiconductor substrate in which a semiconductor layer is on a base substrate. For example, the first substrate 110 may include or be formed of silicon, germanium, silicon-germanium, silicon on insulator, germanium on insulator, or so on. In this instance, the first substrate 110 may include an n-type semiconductor layer that includes an n-type dopant (such as phosphorus (P), arsenic (As), or so on) and/or a p-type semiconductor layer that includes a p-type dopant (such as boron (B), gallium (Ga), or so on). In some example embodiments, the first substrate 110 may be formed of or include a support member including an insulation layer or an insulating material. This is because, after the cell region 100 is bonded to the circuit region 200, a semiconductor substrate included in the cell region 100 may be removed and the support member including the insulation layer or the insulating material may be formed. However, example embodiments are not limited to a material of the first substrate 110, a conductive type of the dopant doped to the semiconductor layer, or so on.

The gate stacking structure 120 may include a plurality of cell insulation layers 132 and a plurality of gate electrodes 130 that are alternately stacked on one surface (e.g., a lower surface of FIG. 2) of the first substrate 110. The channel structure CH may extend in an extension direction that crosses the first substrate 110 and pass through the gate stacking structure 120. For example, the extension direction of the channel structure CH may be a direction that crosses the first substrate 110 (e.g., a vertical direction that is perpendicular to the first substrate 110). The extension direction of the channel structure CH may be a Z-axis direction in the drawing.

The gate electrode 130 may include or be formed of any of various conductive materials. For example, the gate electrode 130 may include a metal material (e.g., tungsten (W), copper (Cu), aluminum (Al), or so on), polycrystalline silicon, metal nitride (e.g., titanium nitride (TiN), tantalum nitride (TaN), tungsten nitride (WN), or so on), or a combination thereof. The cell insulation layer 132 may include or be formed of any of various insulating materials. For example, the cell insulation layer 132 may include silicon oxide, silicon nitride, silicon oxynitride, a low dielectric constant material that has a lower dielectric constant than silicon oxide, or a combination thereof.

The channel structure CH may include a channel layer 140, and a gate dielectric layer 150 on the channel layer 140 between the gate electrode 130 and the channel layer 140. The gate dielectric layer 150 between the gate electrode 130 and the channel layer 140 may include a tunneling layer 152, a charge storage layer 154, and a blocking layer 156 sequentially on the channel layer 140.

The channel structure CH may further include a core insulation layer 142 at an inside of the channel layer 140. In some example embodiments, the core insulation layer 142 might not be provided. The channel structure CH may further include a channel pad 144 on the channel layer 140 and/or the gate dielectric layer 150. The channel pad 144 may cover a surface of the core insulation layer 142 (e.g., a lower surface of the core insulation layer 142 in FIG. 2) and be electrically connected to the channel layer 140.

Each channel structure CH may form one memory cell string, and a plurality of channel structures CH may be spaced apart from each other to form rows and columns in a plan view. For example, in a plan view, the plurality of channel structures CH may be disposed to have a lattice shape, a zigzag shape, or so on. The channel structure CH may have a pillar shape. For example, in a cross-sectional view, the channel structure CH may have an inclined side surface so that a width of the channel structure CH decreases as the channel structure CH approaches the first substrate 110 due to a higher aspect ratio. However, example embodiments are not limited thereto, and an arrangement, a structure, a shape, or so on of the channel structure CH may be variously modified.

The channel layer 140 may include a semiconductor material (e.g., polycrystalline silicon). The core insulation layer 142 may include any of various insulating materials. For example, the core insulation layer 142 may include silicon oxide, silicon nitride, silicon oxynitride, or a combination thereof. The channel pad 144 may include a conductive material (e.g., polycrystalline or single-crystalline silicon doped with a dopant).

The tunneling layer 152 may include an insulating material (e.g., silicon oxide, silicon oxynitride, or so on) that is capable of tunneling a charge. The charge storage layer 154 may be used as a data storage region. The charge storage layer 154 may include or be formed of polycrystalline silicon, silicon nitride, or so on. The blocking layer 156 may include or be formed of an insulating material that is capable of preventing an undesirable flow of charge into the gate electrode 130. For example, the blocking layer 156 may include or be formed of silicon oxide, silicon nitride, silicon oxynitride, a high dielectric constant material that has a higher dielectric constant than silicon oxide, or a combination thereof. In an example embodiment, the blocking layer 156 may include a first blocking layer 156a that includes a portion horizontally extending on the gate electrode 130, and a second blocking layer 156b that vertically extends between the first blocking layer 156a and the charge storage layer 154.

However, example embodiments are not limited to a material, a stacking structure, or so on of the channel layer 140, the core insulation layer 142, and the gate dielectric layer 150.

In an example embodiment, the gate stacking structure 120 may include a plurality of gate stacking portions 121 and 122 that are sequentially stacked on the first substrate 110. Thereby, a number of stacked gate electrodes 130 may be increased and thus a number of memory cells may be increased with a stable structure. In FIG. 2, it is illustrated as an example that the gate stacking structure 120 includes first and second gate stacking portions 121 and 122. However, example embodiments are not limited thereto. In some example embodiments, the gate stacking structure 120 may include one gate stacking portion or three or more gate stacking portions.

When the plurality of gate stacking portions 121 and 122 are provided as in the above, the channel structure CH may include a plurality of channel portions CH1 and CH2 that pass through the plurality of gate stacking portions 121 and 122, respectively. The plurality of channel portions CH1 and CH2 may be connected to each other. In a cross-sectional view, each of the plurality of channel portions CH1 and CH2 may have an inclined side surface such that a width of each of the plurality of channel portions CH1 and CH2 decreases toward the first substrate 110 due to a higher aspect ratio. A bent portion due to a difference in widths of the plurality of channel portions CH1 and CH2 may be provided at a connection portion of the plurality of channel portions CH1 and CH2. In some example embodiments, the plurality of channel portions CH1 and CH2 may have an inclined side surface that continuously extends without the bent portion. In FIG. 3, it is illustrated as an example that each of the gate dielectric layer 150, the channel layer 140, and the core insulation layer 142 of the plurality of channel portions CH1 and CH2 continuously extends to have an integral structure. In some example embodiments, gate dielectric layers 150, channel layers 140, and core insulation layers 142 of a plurality of channel portions CH1 and CH2 may be separately formed and be electrically connected to each other. In some example embodiments, a separate channel pad may be additionally at the connection portion of the plurality of channel portions CH1 and CH2. As such, example embodiments are not limited to a shape of a plurality of channel portions CH1 and CH2.

In an example embodiment, the gate stacking structure 120 may be divided into a plurality of portions in a plan view by a separation structure 146. The separation structure 146 may pass through the gate stacking structure 120. An upper separation region 148 may be at an upper portion (a lower portion in FIG. 2) of the gate stacking structure 120. In a plan view, the separation structure 146 and/or the upper separation region 148 may extend in the first direction (the X-axis direction in the drawings). A plurality of separation structures 146 and/or a plurality of upper separation regions 148 may be spaced apart from each other at desired (or alternatively, predetermined) intervals in the second direction (the Y-axis direction in the drawings) that crosses (e.g., is perpendicular to) the first direction.

In a plan view, the plurality of gate stacking structures 120 may each extend in the first direction (the X-axis direction of the drawing) and be spaced apart from each other at a desired (or alternatively, predetermined) interval in the second direction (the Y-axis direction of the drawing) that crosses the first direction by the separation structure 146. The gate stacking structure 120 divided by the separation structure 146 may constitute one memory cell block. However, example embodiments are not limited thereto, and a range of the memory cell block is not limited thereto.

For example, the separation structure 146 may pass through the gate stacking structure 120 and extend to the first substrate 110, and the upper separation region 148 may separate one or a part of the plurality of gate electrodes 130. The upper separation region 148 may be disposed between the separation structures 146. In cross-sectional view, the separation structure 146 or the upper separation region 148 may pass through the gate stacking structure 120 and extend in an extension direction that crosses the first substrate 110. For example, the extension direction of the separation structure 146 or the upper separation region 148 may be a direction that crosses the first substrate 110 (e.g., a vertical direction that is perpendicular to the first substrate 110) or may be a thickness direction of the bonding semiconductor device 10. The extension direction of the separation structure 146 or the upper separation region 148 may be the Z-axis direction in the drawing.

For example, in a cross-sectional view, the separation structure 146 may have an inclined side surface such that a width of the separation structure 146 gradually decreases toward the first substrate 110 due to a higher aspect ratio. However, example embodiments are not limited thereto. A side surface of the separation structure 146 may be perpendicular to the first substrate 110, or the separation structure 146 may have a bent portion at the connection portion of the first and second gate stacking portions 121 and 122.

The separation structure 146 and/or the upper separation region 148 may include or be formed of any of various insulating materials. For example, the separation structure 146 or the upper separation region 148 may include or be formed of an insulating material such as silicon oxide, silicon nitride, or silicon oxynitride. However, example embodiments are not limited thereto, and a structure, a shape, a material, or so on of the separation structure 146 or the upper separation region 148 may be variously modified.

The connection region 104 and a first wiring portion 180 may be provided to connect the gate stacking structure 120 and the channel structure CH in the cell array region 102 to the circuit region 200 or an external circuit. The connection region 104 may be disposed at a periphery of the cell array region 102 and a partial portion of the first wiring portion 180 may be in the connection region 104.

In an example embodiment, the first wiring portion 180 may include a member electrically connecting the gate electrode 130, the channel structure CH, the first substrate 110, and/or the source connecting portion 110b to the circuit region 200 or an external circuit. For example, the first wiring portion 180 may include a bit line 182, a gate contact portion 184, a source contact portion 186, an input/output connection wiring, a contact via 180a, and a connection wiring 180b. The contact via 180a may be connected to the bit line 182, the gate contact portion 184, the source contact portion 186, and/or the input/output connection wiring. The connection wiring 180b may be electrically connected to the bit line 182, the gate contact portion 184, the source contact portion 186, the input/output connection wiring, and/or the contact via 180a.

The bit line 182 may extend in the second direction (the Y-axis direction in the drawings) that is transverse to or crosses the first direction (the X-axis direction in the drawings) in which the gate electrode 130 extends. The bit line 182 may be electrically connected to the channel structure CH, for example, the channel pad 144.

In the connection region 104, the plurality of gate electrodes 130 may extend in the first direction (the X-axis direction in the drawings). Extension lengths of the plurality of gate electrodes 130 may sequentially decrease in a direction away from the first substrate 110. For example, the plurality of gate electrodes 130 may have a stair shape in one direction or a plurality of directions in the connection region 104. In the connection region 104, a plurality of gate contact portions 184 may pass through the cell insulation layer 132 to be electrically connected to the plurality of gate electrodes 130, respectively, that extend to the connection region 104.

The source contact portion 186 may be electrically connected to the source connecting portion 110b and/or the first substrate 110 that constitutes at least a partial portion of a common source line. The input/output connection wiring may be electrically connected to an input/output pad that is included in the cell region 100. The input/output connection wiring may be electrically connected to a part of first bonding structures 194. In some example embodiments, the circuit region 200 may include an additional input/output pad.

The connection wiring 180b may be disposed in the cell array area 102 and/or the connection area 104. The bit line 182, the gate contact portion 184, the source contact portion 186, and/or the input/output connection wiring may be electrically connected to the connection wiring 180b. For example, the gate contact portion 184, the source contact portion 186, and/or the input/output connection wiring may be electrically connected to the connection wiring 180b through the contact via 180a. The connection wiring 180b may include a plurality of connection wiring layers that are spaced apart from each other while interposing an insulation layer 134 therebetween and are electrically connected by a contact via to form a desired path.

The circuit region 200 may include a second substrate 210, a circuit element 220, a second wiring portion 280, and a second bonding portion 290 that is disposed on the second wiring portion 280. The circuit region 200 may be a semiconductor chip for a bonding semiconductor device, the second substrate 210 may be a substrate, the second wiring portion 280 may be a wiring portion that is disposed on the substrate, and the second bonding portion 290 may be a bonding portion that is disposed on the wiring portion.

The second substrate 210 may be a semiconductor substrate that includes a semiconductor material. For example, the second substrate 210 may be a semiconductor substrate that includes or is formed of a semiconductor material or may be a semiconductor substrate in which a semiconductor layer is on a base substrate. For example, the second substrate 210 may include single-crystalline or polycrystalline silicon, epitaxial silicon, germanium, silicon-germanium, silicon on insulator (SOI), germanium on insulator (GOI), or so on.

The circuit element 220 on the second substrate 210 may include any of various circuit elements and may constitute the peripheral circuit structure that control an operation of the memory cell structure included in the cell region 100. For example, the circuit element 220 may constitute the peripheral circuit structure such as a decoder circuit 1110 (refer to FIG. 28), a page buffer 1120 (refer to FIG. 28), a logic circuit 1130 (refer to FIG. 28), or so on.

The circuit element 220 may include a transistor, but example embodiments are not limited thereto. For example, the circuit element 220 may include not only an active element such as the transistor or so on but also a passive element such as a capacitor, a resistor, an inductor, or so on.

The second wiring portion 280 that is disposed on the second substrate 210 may be electrically connected to the circuit element 220. In an example embodiment, the second wiring portion 280 may include a plurality of wiring layers 286 that are spaced apart from each other while interposing an insulation layer 282 therebetween and are electrically connected by a contact via 284 to form a desired path. The wiring layer 286 or the contact via 284 may include or be formed of any of various conductive materials, and the insulation layer 282 may include or be formed of any of various insulating materials.

The first bonding portion 190 may be disposed at a portion of the cell region 100 that is adjacent to the circuit region 200, and the second bonding portion 290 may be disposed at a portion of the circuit region 200 that is adjacent to the cell region 100. The cell region 100 and the circuit region 200 are bonded to each other through using the first bonding portion 190 and the second bonding portion 290 to form the bonding semiconductor device 10. The first bonding portion 190 may include a first bonding structure or first bonding structures 194 and the second bonding portion 290 may include a second bonding structure or second bonding structures 294. At least a part of the first bonding portions 194 may be electrically connected to the first wiring portion 180. At least a part of the second bonding portions 294 may be electrically connected to the second wiring portion 280.

In an example embodiment, the bit line 182 that is connected to the channel structure CH, the gate electrode 130, the first substrate 110, and/or the source connecting portion 110b may be electrically connected to the circuit element 220 of the circuit region 200, by the first wiring portion 180, the first bonding structure 194, the second bonding structure 294, and the second wiring portion 280.

In FIG. 2, it is illustrated as an example that the gate contact portions 184 and/or the source contact portion 186 has an inclined side surface such that a width of the gate contact portion 184 and/or the source contact portion 186 decreases toward the first substrate 110 due to an aspect ratio and a bent portion is provided at the connection portion of the plurality of gate stacking portions 121 and 122 in a cross-sectional view. However, example embodiments are not limited thereto. In some example embodiments, the gate contact portion 184, the source contact portion 186, and/or the input/output connection wiring might not include the bent portion at the connection portion of the plurality of gate stacking portions 121 and 122. In some example embodiments, in a cross-sectional view, the input/output connection wiring may have an inclined side surface such that a width of the input/output connection wiring decreases toward the circuit region 200. Various modifications are possible.

By a shape, an arrangement, or so on of a structure (e.g., a wiring, a pattern, or so on) disposed on a semiconductor substrate that is included in the bonding semiconductor device 10, a warpage of the semiconductor substrate may occur and thus a warpage of the bonding semiconductor device 10 may occur. The warpage of the semiconductor substrate by the structure disposed on the semiconductor substrate will be described in detail with reference to FIG. 4.

FIG. 4 conceptually illustrates a warpage of a semiconductor substrate 20 according to a shape of a structure 22 disposed on the semiconductor substrate 20.

Referring to FIG. 4, when a plurality of structures 22 extend in one direction, a warpage may occur due to a compressive stress or a tensile stress in an extension direction of the plurality of structures 22.

For example, when the plurality of structures 22 extend in a first direction (an X-axis direction of FIG. 4) on a semiconductor substrate 20 and a compressive stress may occur by the plurality of structures 22, a warpage may occur such that the semiconductor substrate 20 has a convex shape in the first direction. The convex shape may refer to that a surface of the semiconductor substrate 20 on which the structure 22 is disposed has a convex surface and thus the structure 22 is disposed on the convex surface.

For example, when the plurality of structures 22 extend in the first direction (the X-axis direction of FIG. 4) on a semiconductor substrate 20 and a tensile stress may occur by the plurality of structures 22, a warpage may occur such that the semiconductor substrate 20 has a concave shape in the first direction. The concave shape may refer to that a surface of the semiconductor substrate 20 on which the structure 22 is disposed has a concave surface and thus the structure 22 is disposed on the concave surface.

For example, when the plurality of structures 22 extend in a second direction (a Y-axis direction of FIG. 4) on a semiconductor substrate 20 and a compressive stress may occur by the plurality of structures 22, a warpage may occur such that the semiconductor substrate 20 has a convex shape in the second direction. For example, when the plurality of structures 22 extend in the second direction (the Y-axis direction of FIG. 4) on a semiconductor substrate 20 and a tensile stress may occur by the plurality of structures 22, a warpage may occur such that the semiconductor substrate 20 has a concave shape in the second direction.

For example, when the plurality of structures 22 extend in a diagonal direction (a D-axis direction of FIG. 4) on a semiconductor substrate 20 and a compressive stress may occur by the plurality of structures 22, a warpage may occur such that the semiconductor substrate 20 has a convex shape in the diagonal direction. For example, when the plurality of structures 22 extend in a diagonal direction (the D-axis direction of FIG. 4) on a semiconductor substrate 20 and a tensile stress may occur by the plurality of structures 22, a warpage may occur such that the semiconductor substrate 20 has a concave shape in the diagonal direction.

When the warpage of the cell region 100 and/or the circuit region 200 occurs, defects or issues, such as difficulty in performing subsequent processes or bonding misalignment, may occur.

For example, in the cell region 100 of the bonding semiconductor device 10, the plurality of gate electrodes 130 may extend in the first direction (the X-axis direction in the drawings) while being separated by the separation structure 146 that extend in the first direction. For example, a tensile stress may occur by the plurality of gate electrodes 130. Thereby, a warpage may occur such that the cell region 100 has a concave shape in the first direction. When a number of the gate stacking portions 121 and 122 or a number of the gate electrodes 130 increases to increase a data storage capacity, the warpage of the cell region 100 may be larger and may have undesirable effects on subsequent processes. Because the circuit region 200 might not include the separation structure 146 and the gate electrodes 130 of the cell region 100, a warpage of the circuit region 200 may be smaller than the warpage of the cell region 100 before a bonding process.

A region where a relatively large warpage exists or a region where a warpage exists at a level that may have an undesirable effect on subsequent processes may be referred to as a warpage region or a warpage chip. A region where a relatively small warpage exists, a region where a warpage exists at a level that does not have an undesirable effect on subsequent processes, or a region where a warpage does not exist may be referred to as an opposite region or an opposite chip. In an example embodiment, the cell region 100 may be a warpage region or a warpage chip, and the circuit region 200 may be an opposite region or an opposite chip.

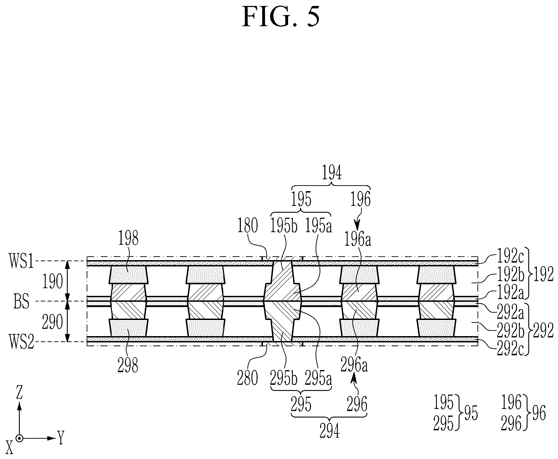

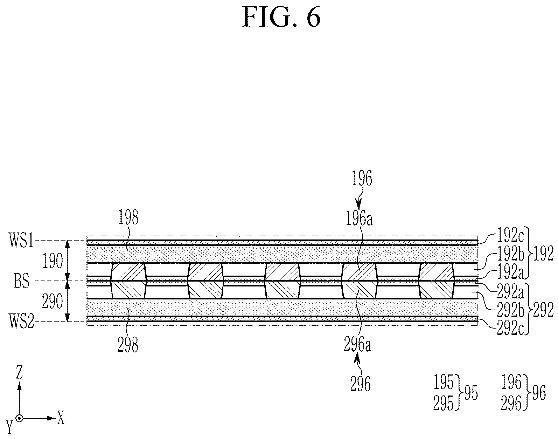

In an example embodiment, the bonding semiconductor device 10 may include an extension pattern 98 configured to reduce or compensate for the warpage issue of the bonding semiconductor device 10. For example, at least one of the cell region 100 or the circuit region 200 may include the extension pattern 98 to reduce the warpage of the cell region 100, which is the warpage region. Referring to FIG. 5 and FIG. 6 together with FIG. 1 and FIG. 2, the first bonding portion 190 and/or the second bonding portion 290 that includes the extension pattern 98 will be described in detail.

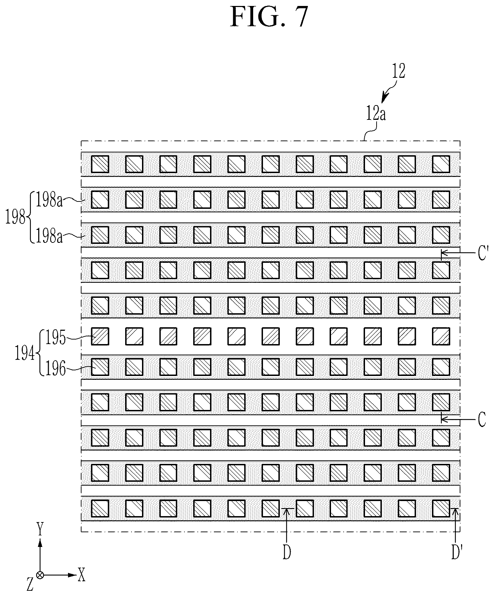

FIG. 5 is a partial cross-sectional view that illustrates a partial portion of the bonding semiconductor device 10 illustrated in FIG. 1. FIG. 6 is a partial cross-sectional view that illustrates a partial portion of the bonding semiconductor device 10 illustrated in FIG. 1. FIG. 5 is a cross-sectional view taken along a line C-C' in FIG. 7. In FIG. 5, the first bonding portion 190 of the cell region 100 and the second bonding portion 290 of the circuit region 200 are mainly illustrated. FIG. 6 is a cross-sectional view taken along a line D-D' in FIG. 7. In FIG. 6, the first bonding portion 190 of the cell region 100 and the second bonding portion 290 of the circuit region 200 are mainly illustrated.

In the specification, the first bonding portion 190 may refer to a portion where the first bonding structure 194 is disposed. For example, the first bonding portion 190 may refer to a portion that is disposed between a first surface of the first bonding structure 194 and a second surface of the first bonding structure 194 in a thickness direction (the Z-axis direction in the drawings) of the bonding semiconductor device 10. In the thickness direction of the bonding semiconductor device 10, the first surface of the first bonding structure 194 may be adjacent to a bonding surface BS and the second surface of the first bonding structure 194 may be opposite to the first surface of the first bonding structure 194. The bonding surface BS may refer to a bonding surface of the cell region 100 and the circuit region 200 and be a surface of the first bonding portion 190 or a surface of the second bonding portion 290 that is opposite to the first wiring portion 180. The second bonding portion 290 may refer to a portion where the second bonding structure 294 is disposed. For example, the second bonding portion 290 may refer to a portion that is disposed between a first surface of the second bonding structure 294 and a second surface of the second bonding structure 294 in the thickness direction of the bonding semiconductor device 10. The first surface of the second bonding structure 294 may be adjacent to the bonding surface BS and the second surface of the second bonding structure 294 may be opposite to the first surface of the second bonding structure 294.

Referring to FIG. 1, FIG. 2, FIG. 5, and FIG. 6, in some example embodiments, the first bonding portion 190 may include a first insulation layer 192, a first bonding structure 194, and a first extension pattern 198. The second bonding portion 290 may include a second insulation layer 292, a second bonding structure 294, and a second extension pattern 298. The first bonding portion 190 and/or the second bonding portion 290 may be a bonding portion 90. The first insulation layer 192 and/or the second insulation layer 292 may be an insulation layer 92, the first bonding structure 194 and/or the second bonding structure 294 may be a bonding structure 94, and the first extension pattern 198 and/or the second extension pattern 298 may be an extension pattern 98.

In an example embodiment, the cell region 100 and the circuit region 200 may be bonded by hybrid bonding. For example, the circuit region 200 and the cell region 100 may be bonded by the hybrid bonding that includes metal bonding between the first bonding structure 194 and the second bonding structure 294 and insulation-layer bonding between the first insulation layer 192 (e.g., a first bonding insulation layer 192a) and the second insulation layer 292 (e.g., a second bonding insulation layer 292a).

In an example embodiment, the first insulation layer 192 may be disposed at a periphery of the first bonding structure 194 and/or the first extension pattern 198 in the first bonding portion 190. The second insulation layer 292 may be disposed at a periphery of the second bonding structure 294 and/or the second extension pattern 298 in the second bonding portion 290. The first insulation layer 192 and/or the second insulation layer 292 may include a single layer or a plurality of layers.

In an example embodiment, the first insulation layer 192 may include a first bonding insulation layer 192a, a first etch stopping layer 192c, and a first base layer 192b. The first bonding insulation layer 192a may be adjacent to the bonding surface BS, the first etch stopping layer 192c may be adjacent to a first adjacent surface WS1, and the first base layer 192b may be disposed between the first bonding insulation layer 192a and the first etch stopping layer 192c. The first base layer 192b may be a portion that is disposed on a lower portion (an upper portion in FIG. 5) of the first bonding insulation layer 192a and has a thickness greater than a thickness of the first bonding insulation layer 192a and/or the first etch stopping layer 192c. The first adjacent surface WS1 may be a surface that is opposite to the bonding surface BS in the first bonding portion 190 or a surface that is adjacent to the first wiring portion 180. The lower portion may refer to a lower portion in a manufacturing process or a portion that is adjacent to the first wiring portion 180.

The second insulation layer 292 may include a second bonding insulation layer 292a, a second etch stopping layer 292c, and a second base layer 292b. The second bonding insulation layer 292a may be adjacent to the bonding surface BS, the second etch stopping layer 292c may be adjacent to a second adjacent surface WS2, and the second base layer 292b may be disposed between the second bonding insulation layer 292a and the second etch stopping layer 292c. The second base layer 292b may be a portion that is disposed on a lower portion (a lower portion in FIG. 5) of the second bonding insulation layer 292a and has a thickness greater than a thickness of the second bonding insulation layer 292a and/or the second etch stopping layer 292c. The second adjacent surface WS2 may be a surface that is opposite to the bonding surface BS in the second bonding portion 290 or a surface that is adjacent to the second wiring portion 280. The lower portion may refer to a lower portion in a manufacturing process or a portion that is adjacent to the second wiring portion 280.

The first bonding insulation layer 192a and/or the second bonding insulation layer 292a may be configured to form the insulation-layer bonding of the circuit region 200 and the cell region 100. The first bonding insulation layer 192a and/or the second bonding insulation layer 292a may include or be formed of an insulating material capable of being bonded to each other. For example, the first bonding insulation layer 192a and/or the second bonding insulation layer 292a may include at least one of SiOx, SiNx, SiCNx, SiOCx, SiONx, or SiOCNx. For example, the first bonding insulation layer 192a and the second bonding insulation layer 292a may include or be formed of the same insulating material. However, example embodiments are not limited thereto.

The first base layer 192b may include or be formed of an insulating material that is chemically stable to electrically insulate the first bonding structure 194, and/or the second base layer 292b may include or be formed of an insulating material that is chemically stable to electrically insulate the second bonding structure 294. For example, the first base layer 192b and/or the second base layer 292b may include or be formed of silicon oxide, but example embodiments are not limited thereto.

The first etch stopping layer 192c and/or the second etch stopping layer 292c may include or be formed of an insulating material, which is different from a material of the first base layer 192b and/or the second base layer 292b. For example, the first etch stopping layer 192c and/or the second etch stopping layer 292c may include or be formed of silicon nitride. However, example embodiments are not limited thereto.

A stacking structure of the first insulation layer 192 or the second insulation layer 292, a material of the first insulation layer 192 or the second insulation layer 292, or so on may be variously modified.

The first bonding structure 194 and the second bonding structure 294 may be configured to form the metal bonding of the circuit region 200 and the cell region 100 or to electrically connect the circuit region 200 and the cell region 100. The first bonding structure 194 and/or the second bonding structure 294 may include or be formed of metal, for example, at least one of copper, aluminum, tungsten, nickel, gold, tin, manganese, cobalt, titanium, tantalum, ruthenium, beryllium, or an alloy including the same. For example, the first and second bonding structures 194 and 294 may include copper so that the cell region 100 and the circuit region 200 may be bonded (e.g., directly bonded) to each other by copper-to-copper bonding.

The first bonding structure 194 may include a first pad structure 195 that is electrically connected to the first wiring portion 180 and a first dummy structure 196 that is not electrically connected to the first wiring portion 180. The second bonding structure 294 may include a second pad structure 295 that is electrically connected to the second wiring portion 280 and a second dummy structure 296 that is not electrically connected to the second wiring portion 280.

The first pad structure 195 and the second pad structure 295 may be bonded to each other by metal bonding, and the first dummy structure 196 and the second dummy structure 296 may be bonded to each other by metal bonding. The first pad structure 195 that is electrically connected to the first wiring portion 180 and the second pad structure 295 that is electrically connected to the second wiring portion 280 may be electrically connected to each other. That is, the first pad structure 195 and the second pad structure 295 may be configured to contribute to the electrical connection between the circuit region 200 and the cell region 100. The first dummy structure 196 and the second dummy structure 296 are bonded to each other by the metal bonding, but are not electrically connected to the first wiring portion 180 and/or the second wiring portion 280. Accordingly, the first dummy structure 196 and the second dummy structure 296 may be portions that do not contribute to the electrical connection between the circuit region 200 and the cell region 100.

The first pad structure 195 may pass through the first insulation layer 192. A first surface of the first pad structure 195 may be adjacent to the circuit region 200 or the bonding surface BS, and a second surface of the first pad structure 195 that is opposite to the first surface of the first pad structure 195 may be adjacent to the first wiring portion 180 or the first adjacent surface WS1. The first pad structure 195 may include a first pad 195a and a first contact via 195b. The first pad 195a may be adjacent to the bonding surface BS and may have a relatively large area. The first contact via 195b may connect the first pad 195a and the first wiring portion 180.

The first dummy structure 196 may pass through a partial portion of the first insulation layer 192. A first surface of the first dummy structure 196 may be adjacent to the circuit region 200 or the bonding surface BS, and a second surface of the first dummy structure 196 that is opposite to the first surface of the first dummy structure 196 may be spaced apart from the first wiring portion 180 or from the first adjacent surface WS1 while interposing the first insulation layer 192 or the first extension pattern 198 therebetween. The first dummy structure 196 may include the first dummy pad 196a that is adjacent to the bonding surface BS, and a width or a planar area of the first dummy pad 196a increases towards the bonding surface BS. The first dummy structure 196 might not include a portion corresponding to the first contact via 195b.

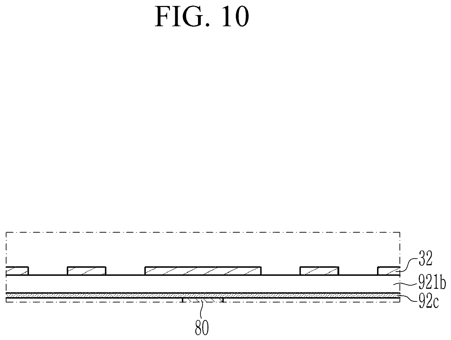

The first pad structure 195 and the first dummy structure 196 may be formed by the same process and may include or be formed of the same material. For example, the first bonding structure 194 that includes the first pad structure 195 and the first dummy structure 196 may be formed by a dual damascene process. This will be described in more detail later with reference to FIG. 10 to FIG. 17.

However, example embodiments are not limited thereto. In some example embodiments, the first pad structure 195 and the first dummy structure 196 may be formed by separate processes, or may include different materials. In some example embodiments, the first pad 195a of the first pad structure 195 and the first contact via 195b of the first pad structure 195 may include or be formed of different materials. Various modifications are possible.

In an example embodiment, a number of first pad structures 195 that are electrically connected to the first wiring portion 180 is relatively small, and a number of the first dummy structures 196 may be greater than the number of the first pad structures 195. However, example embodiments are not limited thereto, and the number of the first dummy structures 196 may be the same as or less than the number of the first pad structures 195.

In an example embodiment, in the bonding surface BS, a plurality of first bonding structures 194 each may have a substantially same planar area and have a substantially same interval therebetween. For example, in the bonding surface BS, a planar area of the first pad 195a of each first pad structure 195 may be substantially same as a planar area of each first dummy pad 196a of the first dummy structure 196. In a plan view, in the bonding surface BS, an interval between the first pads 195a of the first pad structures 195, an interval between the first dummy pads 196a of the first dummy structures 196, and an interval between the first pad 195a and the first dummy pad 196a may be substantially same. Thereby, a density of the first bonding structure 194 may be uniform in a chemical mechanical polishing (CMP) process that is performed in a process for forming the first bonding structure 194.

The second pad structure 295 may pass through the second insulation layer 292. A first surface of the second pad structure 295 may be adjacent to the cell region 100 or the bonding surface BS, and a second surface of the second pad structure 295 that is opposite to the first surface of the second pad structure 295 may be adjacent to the second wiring portion 280 or the second adjacent surface WS2. The second pad structure 295 may include a second pad 295a and a second contact via 295b. The second pad 295a may be adjacent to the bonding surface BS and may have a relatively large area. The second contact via 295b may connect the second pad 295a and the second wiring portion 280.

The second dummy structure 296 may pass through a partial portion of the second insulation layer 292. A first surface of the second dummy structure 296 may be adjacent to the cell region 100 or the bonding surface BS, and a second surface of the second dummy structure 296 that is opposite to the first surface of the second dummy structure 296 may be spaced apart from the second wiring portion 280 or from the second adjacent surface WS2 while interposing the second insulation layer 292 or the second extension pattern 298 therebetween. The second dummy structure 296 may include the second dummy pad 296a that is adjacent to the bonding surface BS has a width or a planar area of the second dummy pad 296a increases towards the bonding surface BS. The second dummy structure 296 might not include a portion corresponding to the second contact via 295b.

The second pad structure 295 and the second dummy structure 296 may be formed by the same process and may include or be formed of the same material. For example, the second bonding structure 294 that includes the second pad structure 295 and the second dummy structure 296 may be formed by a dual damascene process. This will be described in more detail later with reference to FIG. 10 to FIG. 17.

However, example embodiments are not limited thereto. In some example embodiments, the second pad structure 295 and the second dummy structure 296 may be formed by separate processes, or may include different materials. In some example embodiments, the second pad 295a of the second pad structure 295 and the second contact via 295b of the second pad structure 295 may include or be formed of different materials. Various modifications are possible.

In an example embodiment, a number of second pad structures 295 that are electrically connected to the second wiring portion 280 is relatively small, and a number of the second dummy structures 296 may be greater than the number of the second pad structures 295. However, example embodiments are not limited thereto, and the number of the second dummy structures 296 may be the same as or less than the number of the second pad structures 295.

In an example embodiment, in the bonding surface BS, a plurality of second bonding structures 294 each may have a substantially same planar area and have a substantially same interval therebetween. For example, in the bonding surface BS, a planar area of the second pad 295a of each second pad structure 295 may be substantially same as a planar area of the second dummy pad 296a of each second dummy structure 296. In a plan view, in the bonding surface BS, an interval between the second pads 295a of the second pad structures 295, an interval between the second dummy pads 296a of the second dummy structures 296, and an interval between the second pad 295a and the second dummy pad 296a may be substantially same. A density of the second bonding structure 294 may be uniform in a chemical mechanical polishing process that is performed in a process for forming the second bonding structure 294.

In an example embodiment, the extension pattern 98 may include at least one of the first extension pattern 198 and the second extension pattern 298 that is disposed at a lower portion of the dummy structure 96.

The first extension pattern 198 may pass through a partial portion of the first insulation layer 192, and may be disposed between the first wiring portion 180 and the first dummy structure 196. For example, the first extension pattern 198 may pass through the first base layer 192b between the first etch stopping layer 192c and the first dummy structure 196. A first surface of the first extension pattern 198 may be spaced apart from the bonding surface BS while interposing the first dummy structure 196 therebetween. A second surface of the first surface of the first extension pattern 198 that is opposite to the first surface of the first extension pattern 198 may be adjacent to the first adjacent surface WS1 or the first etch stopping layer 192c.

The second extension pattern 298 may pass through a partial portion of the second insulation layer 292, and may be disposed between the second wiring portion 280 and the second dummy structure 296. For example, the second extension pattern 298 may pass through the second base layer 292b between the second etch stopping layer 292c and the second dummy structure 296. A second surface of the second extension pattern 298 may be spaced apart from the bonding surface BS while interposing the second dummy structure 296 therebetween. A second surface of the second surface of the second extension pattern 298 that is opposite to the second surface of the second extension pattern 298 may be adjacent to the second adjacent surface WS2 or the second etch stopping layer 292c.

The first extension pattern 198 and/or the second extension pattern 298 may include or be formed of an insulating material to avoid unwanted effect on the electrical connection. The first extension pattern 198 may include or be formed of a material that is different from a material of at least a partial portion of the first insulation layer 192 (e.g., the first base layer 192b) or may have a composition that is different from a composition of at least a partial portion of the first insulation layer 192 (e.g., the first base layer 192b). The second extension pattern 298 may include or be formed of a material that is different from a material of at least a partial portion of the second insulation layer 292 (e.g., the second base layer 292b), or may have a composition that is different from a composition of at least a partial portion of the second insulation layer 292 (e.g., the second base layer 292b).

The first extension pattern 198 and/or the second extension pattern 298 may include or be formed of a warpage-inducing material that induces a warpage being capable of reducing the warpage of the cell region 100 and/or the circuit region 200. For example, the warpage-inducing material of the first extension pattern 198 and/or the second extension pattern 298 may induce a warpage in a direction that is opposite to a direction of the warpage of the cell region 100 and/or the circuit region 200. The first extension pattern 198 and/or the second extension pattern 298 may include a compressive-stress material or a tensile-stress material. The compressive-stress material may have a stress of a negative number at a room temperature and apply a compressive stress when the compressive-stress material is disposed on a substrate. The tensile-stress material may have a stress of a positive number at a room temperature and apply a tensile stress when the tensile-stress material is disposed on a substrate.

For example, the first extension pattern 198 and/or the second extension pattern 298 may include or be formed of at least one of oxide, nitride, carbonitride, oxycarbide, oxynitride, oxycarbonitride, or a resin. For example, the first extension pattern 198 and/or the second extension pattern 298 may include or be formed of at least one of silicon oxide, aluminum oxide, hafnium oxide, silicon nitride, silicon carbonitride (SiCN), silicon oxycarbide (SiOC), silicon oxynitride (SiON), silicon oxycarbonitride (SiOCN), or a resin.

Silicon oxide, aluminum oxide, or hafnium oxide may be the compressive-stress material. Silicon nitride or silicon carbonitride may be the tensile-stress material. Silicon oxycarbide, silicon oxynitride, or silicon oxycarbonitride may be the compressive-stress material or the tensile-stress material according to a composition. The resin may be generally the tensile-stress material, but the resin may be the compressive-stress material according to a material or a composition.

The compressive stress or the tensile stress of the first extension pattern 198 and/or the second extension pattern 298 may be adjusted by adjusting a composition, a manufacturing process, a process condition, or so on of the first extension pattern 198 and/or the second extension pattern 298.

The first extension pattern 198 may include or be formed of a material that is different from a material of the first bonding insulation layer 192a and/or the first etch stopping layer 192c or may have a composition that is different from a composition of the first bonding insulation layer 192a and/or the first etch stopping layer 192c. The second extension pattern 298 may include or be formed of a material that is different from a material of the second bonding insulation layer 292a and/or the second etch stopping layer 292c, or may have a composition that is different from a composition of the second bonding insulation layer 292a and/or the second etch stopping layer 292c. However, example embodiments are not limited thereto. The first extension pattern 198 may include or be formed of a material that is the same as a material of the first bonding insulation layer 192a and/or the first etch stopping layer 192c or may have a composition that is the same as a composition of the first bonding insulation layer 192a and/or the first etch stopping layer 192c. The second extension pattern 298 may include or be formed of a material that is the same as a material of the second bonding insulation layer 292a and/or the second etch stopping layer 292c, or may have a composition that is the same as a composition of the second bonding insulation layer 292a and/or the second etch stopping layer 292c.

In some example embodiments, the first extension pattern 198 may include or be formed of a material different from a material of the first base layer 192b. In some example embodiments, the first extension pattern 198 may include the same oxide (e.g., silicon oxide) as the first base layer 192b and the first extension pattern 198 may have a composition different from a composition of the first base layer 192b. For example, a volume percent (vol%) of a by-product in the first extension pattern 198 may be less than a volume percent (vol%) of a by-product in the first base layer 192b. The by-product may refer to a material other than oxide. An atomic percent (at%) of hydrogen in the first extension pattern 198 may be less than an atomic percent (at%) of hydrogen in the first base layer 192b. A volume percent (vol%) of oxide in the first extension pattern 198 may be greater than a volume percent (vol%) of oxide in the first base layer 192b. An etch rate of an etching material to the first extension pattern 198 may be less than an etch rate of the etching material to the first base layer 192b. The etching material may be formed of or include a material that etches oxide (e.g., silicon oxide), for example, a hydrofluoric acid. Absolute value of the compressive stress of the first extension pattern 198 at a room temperature may be greater than absolute value of the compressive stress of the first base layer 192b at a room temperature.

In some example embodiments, the second extension pattern 298 may include or be formed of a material different from a material of the second base layer 292b. In some example embodiments, the second extension pattern 298 may include the same oxide (e.g., silicon oxide) as the second base layer 292b and the second extension pattern 298 may have a composition different from a composition of the second base layer 292b. For example, a volume percent (vol%) of a by-product in the second extension pattern 298 may be less than a volume percent (vol%) of a by-product in the second base layer 292b. The by-product may refer to a material other than oxide. An atomic percent (at%) of hydrogen in the second extension pattern 298 may be less than an atomic percent (at%) of hydrogen in the second base layer 292b. A volume percent (vol%) of oxide in the second extension pattern 298 may be greater than a volume percent (vol%) of oxide in the second base layer 292b. An etch rate of an etching material to the second extension pattern 298 may be less than an etch rate of the etching material to the second base layer 292b. The etching material may be formed of or include a material that etches oxide (e.g., silicon oxide), for example, a hydrofluoric acid. Absolute value of the compressive stress of the second extension pattern 298 at a room temperature may be greater than absolute value of the compressive stress of the second base layer 292b at a room temperature.

The first extension pattern 198 and/or the second extension pattern 298 may have a shape that applies a stress being capable of reducing the warpage of the cell region 100 and/or the circuit region 200. For example, the first extension pattern 198 and/or the second extension pattern 298 may have a shape that applies a stress in a direction that is opposite to a direction of the warpage of the cell region 100 and/or the circuit region 200. For example, in a plan view, the first extension pattern 198 and/or the second extension pattern 298 may include an extension portion that extends in one direction. The extension portion may extend in a direction parallel to a direction where a warpage occurs. The first extension pattern 198 and/or the second extension pattern 298, or the extension portion included in the same may continuously connect a plurality of first bonding structures 194 and/or a plurality of second bonding structure 294 (e.g., a plurality of first dummy structures 196 and/or a plurality of second dummy structures 296) that are spaced apart from each other with a regular interval in the direction parallel to the direction along which the warpage occurs. A shape, a position, or so on of the first extension pattern 198 and/or the second extension pattern 298 will be described in more detail later.

As in the above, the first extension pattern 198 and/or the second extension pattern 298 may include a material or have a shape that induces a warpage being capable of reducing (e.g., compensating for) the warpage of the cell region 100 and/or the circuit region 200, thereby reducing the warpage of the cell region 100 and/or the circuit region 200.

Further, the first extension pattern 198 and/or the second extension pattern 298 may act as an etch stopping pattern in a process of etching a partial portion of the first insulation layer 192 and/or the second insulation layer 292 to form the first dummy structure 196 and/or the second dummy structure 296. For example, an etching process may be properly controlled in a process of forming the first bonding structure 194 and/or the second bonding structure 294 using the dual damascene process. Accordingly, it effectively reduces or prevents the first dummy structure 196 and/or the second dummy structure 296 from being undesirably electrically connected to the first wiring portion 180 and/or the second wiring portion 280. Thereby, without increase in a thickness of the first insulation layer 192 and/or the second insulation layer 292, a margin of a breakdown voltage with the first wiring portion 180 and/or the second wiring portion 280 may be secured. Thus, the etching process may be easily performed.

Accordingly, the extension pattern 98, or the first extension pattern 198 and/or the second extension pattern 298 may be referred to as a warpage reducing pattern, a warpage preventing pattern, a warpage inducing pattern, a skew reducing pattern, a skew preventing pattern, an etch stopping pattern, a multi-functional pattern that performs various functions, an intercalated pattern, or so on. The warpage inducing pattern may induce a warpage in a direction that is opposite to a direction of the warpage of the cell region 100 and/or the circuit region 200.

As in the above, the first dummy structure 196 might not include the portion corresponding to the first contact via 195b, and the second dummy structure 296 might not include the portion corresponding to second contact via 295b. When a number of the first dummy structures 196 and/or a number the second dummy structures 296 is relatively large, an area where the first contact vias 195b are not disposed is large (e.g., is increased) in the first bonding portion 190 and/or an area where the second contact vias 295b are not disposed is large (e.g., is increased) in the second bonding portion 290. Accordingly, there is a large empty space may be disposed at a lower portion of the first dummy structures 196 and/or the second dummy structures 296. In an example embodiment, in the large or increased empty space at the lower portion of the first dummy structures 196 and/or the second dummy structures 296, the first extension pattern 198 and/or the second extension pattern 298 is disposed and thus an additional space for the first extension pattern 198 and/or the second extension pattern 298 is not needed (or may not be desired).

In an example embodiment, a width of at least a partial portion of the first extension pattern 198 may be greater than a width of the first dummy structure 196, and/or a width of at least a partial portion of the second extension pattern 298 may be greater than a width of the second dummy structure 296. The width of the first extension pattern 198 or the width of the second extension pattern 298 may refer to a minimum width or refer to a width when viewed in a cross-sectional view in a direction that is transverse (e.g. perpendicular) to the first dummy structure 196 or the second dummy structure 296. The width of the first dummy structure 196 or the width of the second dummy structure 296 may refer to a minimum width or a width in a direction that is transverse (e.g. perpendicular) to the first extension pattern 198 or the second extension pattern 298. For example, in a cross-sectional view that crosses (e.g., is perpendicular to) the first extension pattern 198 or the second extension pattern 298, the width of the first extension pattern 198 may be greater than the width of the first dummy structure 196, and/or the width of the second extension pattern 298 may be greater than the width of the second dummy structure 296.

An entire portion of at least one first dummy structure 196 (e.g., each of the plurality of first dummy structures 196) may be disposed on the first extension pattern 198, and/or an entire portion of at least one second dummy structure 296 (e.g., each of the plurality of second dummy structures 296) may be disposed on the second extension pattern 298. Thereby, in a process of forming the first dummy structure 196 and/or the second dummy structure 296, the first extension pattern 198 and/or the second extension pattern 298 may stably act as the etch stopping pattern. Further, the first extension pattern 198 and/or the second extension pattern 298 may have a sufficient planar area, and thus, the first extension pattern 198 and/or the second extension pattern 298 may stably act as the warpage reducing pattern.

However, example embodiments are not limited thereto. The width of at least a partial portion of the first extension pattern 198 may be the same as or smaller than the width of the first dummy structure 196, and/or the width of at least a partial portion of may be the same as or smaller than the width of the second dummy structure 296. In some example embodiments, at least one first dummy structure 196 or a partial portion of the first dummy structure 196 may be disposed on the first extension pattern 198, and another first dummy structure 196 or another portion of the first dummy structure 196 might not be disposed on the first extension pattern 198. In some example embodiments, at least one second dummy structure 296 or a partial portion of the second dummy structure 296 may be disposed on the second extension pattern 298, and another second dummy structure 296 or another portion of the second dummy structure 296 might not be disposed on the second extension pattern 298. Various modifications are possible.

In an example embodiment, a thickness of the first extension pattern 198 may be greater than a thickness of the first dummy structure 196, and/or a thickness of the second extension pattern 298 may be greater than a thickness of the second dummy structure 296. Thereby, in a process of forming the first dummy structure 196 and/or the second dummy structure 296, the first extension pattern 198 and/or the second extension pattern 298 may stably act as the etch stopping pattern. Further, the first extension pattern 198 and/or the second extension pattern 298 may have a sufficient volume, and thus, the first extension pattern 198 and/or the second extension pattern 298 may stably act as the warpage reducing pattern. However, example embodiments are not limited thereto. When the warpage of the cell region 100 and/or the circuit region 200 is not large (e.g., relatively small) or the warpage preventing effect by the first extension pattern 198 and/or the second extension pattern 298 is sufficient, a thickness of the first extension pattern 198 and/or the second extension pattern 298 may be the same as or smaller than a thickness of the first dummy structure 196 and/or the second dummy structure 296.

In an example embodiment, by adjusting a material, a volume, a width, a thickness, a shape, a position, an arrangement, or so on of the first extension pattern 198 and/or the second extension pattern 298, the warpage of the cell region 100 and/or the circuit region 200 may be effectively reduced and/or be precisely controlled. The warpage in various directions, for example, the first direction (the X-axis direction in the drawings), the second direction (the Y-axis direction in the drawings), and/or a diagonal direction may be reduced or compensated for.

In some example embodiments, in a case that the cell region 100 is the warpage region having a warpage with a concave shape in the first direction (the X-axis direction in the drawings) by the tensile stress of the plurality of gate electrodes 130, a position, a shape, or so on of the first extension pattern 198 and the second extension pattern 298 will be described in detail with reference to FIG. 7 to FIG. 9 together with FIG. 1, FIG. 2, FIG. 5, and FIG. 6.

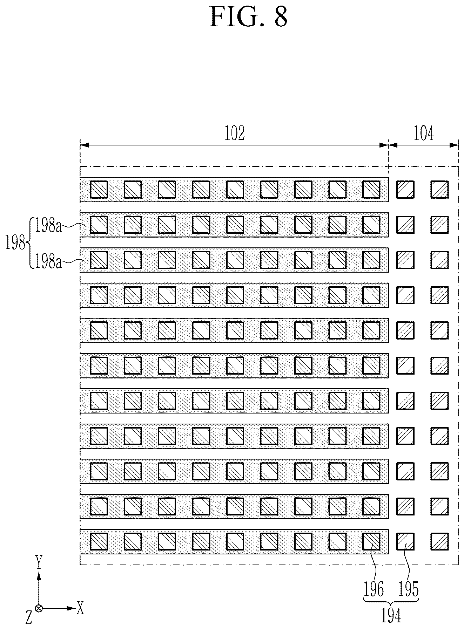

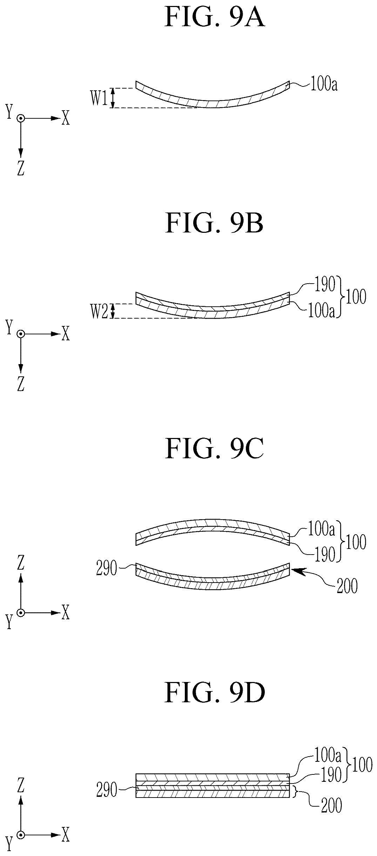

FIG. 7 is an enlarged plan view of a portion A of FIG. 1. FIG. 8 is an enlarged plan view of a portion B of FIG. 1. FIG. 7 is a rear plan view of the cell region 100 that mainly illustrates the first bonding structure 194 and the first extension pattern 198 included in the portion A. FIG. 8 is a rear plan view of the cell region 100 that mainly illustrates the first bonding structure 194 and the first extension pattern 198 included in the portion B. FIG. 9 conceptually illustrates warpage reduction in the cell region 100 by the first extension pattern 198 included in the cell region 100 and the second extension pattern 298 included in the circuit region 200 in a case that the cell region 100 is the warpage region.

Referring to FIG. 1, FIG. 2, and FIG. 5 to FIG. 9, in some example embodiments, the first extension pattern 198 may include or be formed of a material and/or have a shape configured to reduce the warpage of the cell region 100 that is the warpage region.

The first extension pattern 198 may include or be formed of a material configured to reduce the warpage of the cell region 100. That is, the first extension pattern 198 may include a compressive-stress material that induce a stress (e.g. a compressive stress) opposite to the stress (e.g., the tensile stress) by the gate electrodes 130. For example, the first extension pattern 198 may include or be formed of oxide (e.g., silicon oxide, aluminum oxide, or hafnium oxide), silicon oxycarbide, silicon oxynitride, silicon oxycarbonitride, or so on. As illustrated in FIG. 7 and FIG. 8, the first extension pattern 198 may include a first extension portion 198a that extends in the first direction (the X-axis direction in the drawings). More particularly, a plurality of first extension patterns 198 or a plurality of first extension portions 198a may extend in the first direction and be spaced apart from each other at a regular interval in the second direction (the Y-axis direction in the drawings). When the first extension pattern 198 or the first extension portion 198a may be included in plural, the warpage of the cell region 100 may be effectively reduced or prevented.

The first extension pattern 198 or the first extension portion 198a may continuously connect the plurality of first dummy structures 196 (e.g., the plurality of first dummy pads 196a) that are spaced apart from each other with a regular interval in the first direction (the X-axis direction in the drawings). The first extension pattern 198 or the first extension portion 198a might not be disposed in an area where the first pad structure 195 is disposed.

For example, as illustrated in FIG. 7, a plurality of first extension patterns 198 or a plurality of first extension portions 198a may extend in the first direction (the X-axis direction in the drawings) in the partition portion 12 that divides, partitions, or defines the memory regions 10m. The first extension pattern 198 or the first extension portion 198a may extend to continuously connect at least two first dummy structures 196 among the plurality of first dummy structures 196 in the partition portion 12. In some example embodiments, the first extension portion 198a may longitudinally extend to continuously connect the plurality of first dummy structures 196 that are disposed between both edges of the bonding semiconductor device 10.

In FIG. 1 and FIG. 7, it is illustrated as an example that the first extension pattern 198 or the first extension portion 198a is disposed in the first partition portion 12a that extends in the first direction (the X-axis direction in the drawings) between the memory regions 10m that are adjacent to each other in the second direction (the Y-axis direction in the drawings). The plurality of first pad structures 195 may be spaced apart from each other to form one row in the first direction at a central portion of the partition portion 12 or 12a when viewed in the second direction. One or a plurality of first extension patterns 198 or one or a plurality of first extension portions 198a may be disposed between the first pad structure 195 and the memory region 10m in the second direction. Thereby, a structural stability may be enhanced, but example embodiments are not limited thereto.

For a clear understanding, FIG. 1 and FIG. 7 illustrate an example of the first extension pattern 198 or the first extension portion 198a. A shape, a position, an arrangement, a length, or so on of the first extension pattern 198 or the first extension portion 198a may be variously modified.

For example, as illustrated in FIG. 8, a plurality of first extension patterns 198 or a plurality of first extension portions 198a may be disposed in the memory region 10m.

The plurality of first extension patterns 198 or the plurality of first extension portions 198a may extend in the first direction (the X-axis direction in the drawings) in the memory region 10m. The first extension pattern 198 or the first extension portion 198a may extend to continuously connect at least two first dummy structures 196 among the plurality of first dummy structures 196 in the memory region 10m. In some example embodiments, the first extension portion 198a may longitudinally extend to continuously connect the plurality of first dummy structures 196 between the connection regions 104 that are disposed at both sides of the gate stacking structure 120. In some example embodiments, the first extension portion 198a may longitudinally extend to continuously connect the plurality of first dummy structures 196 between the both edges of the bonding semiconductor device 10.

In FIG. 1 and FIG. 8, it is illustrated as an example that the first extension pattern 198 is disposed in the cell array region 102 without the first pad structure 195, and the first pad structure 195 is disposed in the connection region 104 without the first extension pattern 198. However, example embodiments are not limited thereto. The first pad structure 195 and/or the first extension pattern 198 may be disposed in the cell array region 102, and/or the first pad structure 195 and/or the first extension pattern 198 may be disposed in the connection region 104. In FIG. 1, it is illustrated as an example that the first extension pattern 198 may be disposed in the cell array region 102 that are disposed between the connection regions 104 at both sides, and may be disposed in a portion where the connection region 104 is not disposed (a lower portion of the memory region 10m in FIG. 1). Thereby, the first extension pattern 198 may be uniformly disposed in a large planar area, and thus, the first extension pattern 198 may stably act as the warpage reducing pattern.

However, example embodiments are not limited thereto. In some example embodiments, the first extension pattern 198 may be disposed in the cell array region 102 that are disposed between the connection regions 104 at both sides, and might not be disposed in the portion where the connection region 104 is not disposed (the lower portion of the memory region 10m in FIG. 1). Thereby, the first extension pattern 198 may be disposed to correspond to a portion where the gate electrodes 130 that induces the warpage, and thus the warpage by the gate electrodes 130 may be reduced or compensated for. In some example embodiments, the first extension pattern 198 may be disposed in a partial portion of the cell array region 102 that are disposed between the connection regions 104, and may be disposed in a portion other than the cell array region 102 that are disposed between the connection regions 104. Various modifications are possible.

For a clear understanding, FIG. 1 and FIG. 8 illustrate an example of the first extension pattern 198 or the first extension portion 198a. Accordingly, a shape, a position, an arrangement, a length, or so on of the first extension pattern 198 or the first extension portion 198a may be variously modified.

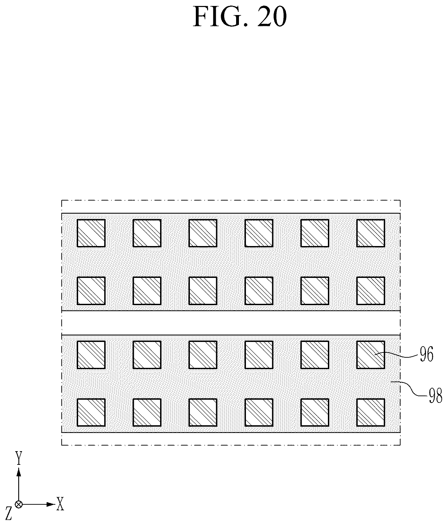

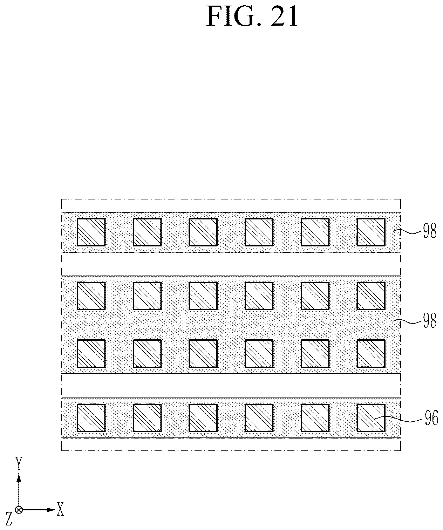

In FIG. 7 and FIG. 8, it is illustrated as an example that each first extension pattern 198 or each first extension portion 198a corresponds to one first dummy structure 196 in the second direction (the Y-axis direction in the drawings). However, example embodiments are not limited thereto. Other example embodiments will be described in detail later with reference to FIG. 20 and FIG. 21.

In an example embodiment, the second extension pattern 298 that is included in the circuit region 200 may include or be formed of a material and/or have a shape configured to reduce or compensate for the warpage of the cell region 100 that is the warpage region.

In this instance, the first extension pattern 198 may include a compressive-stress material that induce a stress (e.g. a compressive stress) opposite to the stress (e.g., the tensile stress) by the gate electrodes 130.

The second extension pattern 298 may include a material that induce a stress (e.g. a tensile stress) the same as the stress (e.g., the tensile stress) by the gate electrodes 130.

The second extension pattern 298 may include or be formed of a material configured to reduce the warpage of the cell region 100. Because the cell region 100 is reversely bonded to the circuit region 200, the second extension pattern 298 of the circuit region 200 may include a tensile-stress material to reduce or compensate for the warpage of the cell region 100 by the tensile stress. That is, the second extension pattern 298 may include a tensile-stress material that induce a stress (e.g. a tensile stress) the same as the stress (e.g., the tensile stress) by the gate electrodes 130. This will be described in more detail later with reference to FIG. 9. For example, the second extension pattern 298 may include or be formed of nitride (e.g., silicon nitride), silicon carbonitride, silicon oxycarbide, silicon oxynitride, silicon oxycarbonitride, a resin, or so on. The second extension pattern 298 may include a first extension portion that extends in the first direction (the X-axis direction in the drawings). For example, a plurality of second extension patterns 298 or a plurality of first extension portions included in the plurality of second extension patterns 298 may extend in the first direction and be spaced apart from each other at a regular interval in the second direction (the Y-axis direction in the drawings). When the second extension pattern 298 or the first extension portion included in the second extension pattern 298 may be included in plural, the warpage of the cell region 100 may be effectively prevented.

The second extension pattern 298 or the first extension portion included in the second extension pattern 298 may continuously connect the plurality of second dummy structures 296 (e.g., the plurality of second dummy pads 296a) that are spaced apart from each other with a regular interval in the first direction (the X-axis direction in the drawings). The second extension pattern 298 or the first extension portion included in the second extension pattern 298 might not be disposed in an area where the second pad structure 295 is disposed.

For example, in a plan view, the plurality of second extension patterns 298 may be disposed to correspond to the plurality of first extension patterns 198 in the partition portion 12 and/or the memory region 10m.

For example, the plurality of second extension patterns 298 or the plurality of first extension portions included in the plurality of second extension patterns 298 may extend in the first direction (the X-axis direction in the drawings) in the partition portion 12 that divides, partitions, or defines the memory regions 10m. The second extension pattern 298 or the first extension portion included in the second extension pattern 298 may extend to continuously connect at least two second dummy structures 296 among the plurality of second dummy structures 296 in the partition portion 12. In some example embodiments, the second extension pattern 298 or the first extension portion included in the second extension pattern 298 may longitudinally extend to continuously connect the plurality of second dummy structures 296 that are disposed between both edges of the bonding semiconductor device 10.

The plurality of second extension patterns 298 or the plurality of first extension portions included in the plurality of second extension patterns 298 may extend in the first direction (the X-axis direction in the drawings) in the memory region 10m. The second extension pattern 298 or the first extension portion included in the second extension pattern 298 may extend to continuously connect at least two second dummy structures 296 among the plurality of second dummy structures 296 in the memory region 10m. In some example embodiments, the second extension pattern 298 or the first extension portion included in the second extension pattern 298 may longitudinally extend to continuously connect the plurality of second dummy structures 296 between the connection regions 104. In some example embodiments, the second extension pattern 298 or the first extension portion included in the second extension pattern 298 may longitudinally extend to continuously connect the plurality of second dummy structures 296 between the both edges of the bonding semiconductor device 10.

The other description to the first extension pattern 198 or the first extension portion 198a may be applied to the second extension pattern 298 or the first extension portion included in the second extension pattern 298.

However, example embodiments are not limited thereto. The cell region 100 and the circuit region 200 may have different structures, and thus, the second extension pattern 298 may be additionally disposed in a portion where the first extension pattern 198 is not disposed or the second extension pattern 298 may be disposed in a different position from the first extension pattern 198.

As illustrated in FIG. 9A, a base region 100a of the cell region 100, which is other than the first bonding portion 190, may have a concave shape in the first direction (the X-axis direction in the drawings) by the warpage. The base region 100a may have a relatively large first warpage W1.

As illustrated in FIG. 9B. when the first bonding portion 190 including the first extension pattern 198 is disposed on the base region 100a, the cell region 100 may have a relatively small second warpage W2 (e.g. a second warpage W2 reduced from the first warpage W1) by the first extension pattern 198 configured to reduce or compensate for the warpage of the cell region 100

As illustrated in FIG. 9C, in a bonding process where the cell region 100 and the circuit region 200 are bonded, the cell region 100 is reversely bonded to the circuit region 200. When the cell region 100 is reversed in a vertical direction, a central portion of the cell region 100 may protrude than an edge portion of the cell 100 so that the central portion of the cell region 100 may farther form the circuit region 200 than the edge portion of the cell region 100. Accordingly, when the circuit region 200 has a shape that is opposite to the shape of the cell region 100, the warpage of the cell region 100 may be reduced or compensated for. Accordingly, the second extension pattern 298 included in the second bonding portion 290 of the circuit region 200 may include the tensile-stress material. When the cell region 100 and the circuit region 200 have opposite shapes, the warpage of the cell region 100 may be compensated by the warpage of the circuit region 200, as illustrated in FIG. 9D. Thereby, the warpage of the bonding semiconductor device 10 may be reduced or compensated for below a certain level or the warpage of the bonding semiconductor device 10 does not exist substantially.

In FIG. 9B, it is illustrated as an example that the cell region 100 has the relatively small second warpage W2 by the first extension pattern 198. In some example embodiments, the warpage of the cell region 100 might not exist substantially by the first extension pattern 198. In this instance, the second extension pattern 298 included in the circuit region 200 may be omitted.

In the above, it is described as an example that the warpage of the cell region 100 occurs in the first direction (the X-axis direction in the drawings) by the tensile stress.

In some example embodiments, when a warpage of the cell region 100 occurs in the first direction (the X-axis direction in the drawings) by a compressive stress, the first extension pattern 198 may include a tensile-stress material, and/or the second extension pattern 298 may include a compressive-stress material. In this instance, the first extension pattern 198 and/or the second extension pattern 298 may include a plurality of first extension portions that extend in the first direction.

In some example embodiments, when a warpage of the cell region 100 occurs in the second direction (the Y-axis direction in the drawings) by a tensile stress, the first extension pattern 198 may include a compressive-stress material, and/or the second extension pattern 298 may include a tensile-stress material. In this instance, the first extension pattern 198 and/or the second extension pattern 298 may include a plurality of second extension portions that extend in the second direction.

In some example embodiments, when a warpage of the cell region 100 occurs in the second direction (the Y-axis direction in the drawings) by a compressive stress, the first extension pattern 198 may include a tensile-stress material, and/or the second extension pattern 298 may include a compressive-stress material. In this instance, the first extension pattern 198 and/or the second extension pattern 298 may include a plurality of second extension portions that extend in the second direction.

In some example embodiments, when a warpage of the cell region 100 occurs in a third direction (e.g. a diagonal direction) by a tensile stress, the first extension pattern 198 may include a compressive-stress material, and/or the second extension pattern 298 may include a tensile-stress material. In this instance, the first extension pattern 198 and/or the second extension pattern 298 may include a plurality of third extension portions that extend in the third direction (e.g. the diagonal direction).

In some example embodiments, when a warpage of the cell region 100 occurs in the third direction (e.g. the diagonal direction) by a compressive stress, the first extension pattern 198 may include a tensile-stress material, and/or the second extension pattern 298 may include a compressive-stress material. In this instance, the first extension pattern 198 and/or the second extension pattern 298 may include a plurality of third extension portions that extend in the third direction (e.g. the diagonal direction).

In the above, it is described as an example that the cell region 100 is the warpage region and the circuit region 200 is the opposite region, and the cell region 100 and the circuit region 200 include the first extension pattern 198 and the second extension pattern 298, respectively, to reduce or compensate for the warpage of the cell region 100. By the first extension pattern 198 and the second extension pattern 298, the warpage of the warpage region may be effectively reduced or compensated for. However, example embodiments are not limited thereto.

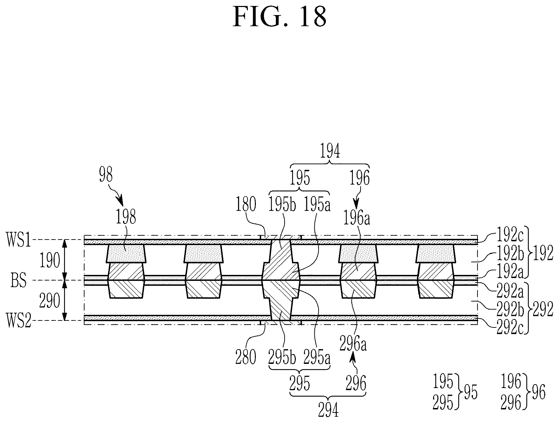

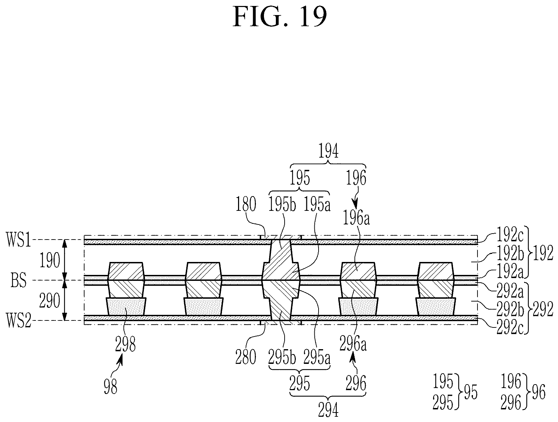

In some example embodiments, in a case that that the cell region 100 is a warpage region and the circuit region 200 is an opposite region, and the extension pattern 98 may be included in one of the cell region 100 and the circuit region 200 and may be omitted in the other of the cell region 100 and the circuit region 200. This will be described in more detail later with reference to FIG. 18 and FIG. 19.

In some example embodiments, the cell region 100 may be a warpage region and the circuit region 200 may be a warpage region. In this instance, the first extension pattern 198 may be included in the cell region 100 to reduce or compensate for the warpage of the cell region 100 and/or the circuit region 200, and/or the second extension pattern 298 may be included in the circuit region 200 to reduce or compensate for the warpage of the cell region 100 and/or the circuit region 200. The second extension pattern 298 may be included without the first extension pattern 198, the first extension pattern 198 may be included without the second extension pattern 298, or the first extension pattern 198 and the second extension pattern 298 may be included together. The first extension pattern 198 and/or the second extension pattern 298 may have a shape and/or include or be formed of a material configured to reduce or compensate for the warpage of the cell region 100 and/or the circuit region 200.

In some example embodiments, the circuit region 200 may be a warpage region and the cell region 100 may be an opposite region to the circuit region 200. The first extension pattern 198 may be included in the cell region 100 to reduce or compensate for the warpage of the circuit region 200, and/or the second extension pattern 298 may be included in the circuit region 200 to reduce or compensate for the warpage of the circuit region 200. The second extension pattern 298 may be included without the first extension pattern 198, the first extension pattern 198 may be included without the second extension pattern 298, or the first extension pattern 198 and the second extension pattern 298 may be included together. The first extension pattern 198 and/or the second extension pattern 298 may have a shape and/or include or be formed of a material configured to reduce or compensate for the warpage of the circuit region 200.

A manufacturing method of a bonding portion 90 that includes an extension pattern 98 according to an example embodiment will be described in detail with reference to FIG. 10 to FIG. 17 together with FIG. 1 to FIG. 9. The following description of the bonding portion 90 may be applied to a first bonding portion 190, and/or may be applied to a second bonding portion 290.

For example, the following description of an insulation layer 92 that includes an etch stopping layer 92c, a base layer 92b, and a bonding insulation layer 92a may be applied to a first insulation layer 192 that includes a first etch stopping layer 192c, a first base layer 192b, and a first bonding insulation layer 192a. The following description of a bonding structure 94 that includes a pad structure 95 and a dummy structure 96 may be applied to a first bonding structure 194 that includes a first pad structure 195 and a first dummy structure 196. The following description of an extension pattern 98 may be applied to a first extension pattern 198. The following description of a wiring portion 80 may be applied to a first wiring portion 180.

For example, the following description of the insulation layer 92 that includes the etch stopping layer 92c, the base layer 92b, and the bonding insulation layer 92a may be applied to a second insulation layer 292 that includes a second etch stopping layer 292c, a second base layer 292b, and a second bonding insulation layer 292a. The following description of the bonding structure 94 that includes the pad structure 95 and the dummy structure 96 may be applied to a second bonding structure 294 that includes a second pad structure 295 and a second dummy structure 296. The following description of the extension pattern 98 may be applied to a second extension pattern 298. The following description of the wiring portion 80 may be applied to a second wiring portion 280.

FIG. 10 to FIG. 17 are partial cross-sectional views that illustrate a manufacturing method of a bonding portion 90 included in the bonding semiconductor device 10 illustrated in FIG. 1. FIG. 10 to FIG. 17 illustrate a portion corresponding to one bonding portion 90 (a first bonding portion 190 or a second bonding portion 290) in a portion illustrated in FIG. 5.

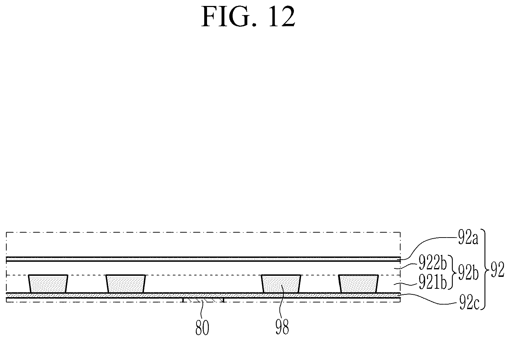

As illustrated in FIG. 10, an etch stopping layer 92c and a first base portion 921b of a base layer 92b (refer to refer to FIG. 12) may be formed on a wiring portion 80. The etch stopping layer 92c and/or the first base portion 921b may be formed by any of various processes (e.g., a deposition process).

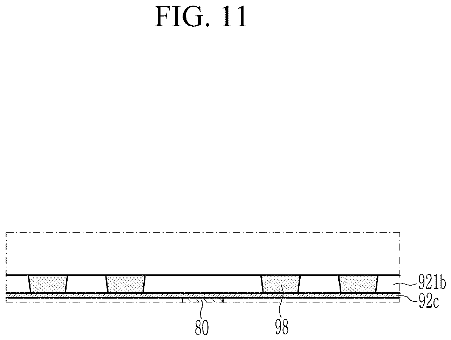

A first mask layer 32 that exposes a portion where an extension pattern 98 (refer to FIG. 11) will be disposed may be formed on the first base portion 921b. The first mask layer 32 may be formed by a photo lithography process. For example, a cleaning process may be formed before the first mask layer 32 is formed, and the photolithography process may be formed. However, example embodiments are not limited thereto.

Subsequently, as illustrated in FIG. 11, a recess for an extension pattern may be formed in the first base portion 921b by an etching process using the first mask layer 32 (refer to FIG. 10) and a warpage inducing material may be formed or filled in the recess for the extension pattern to form the extension pattern 98. The first mask layer 32 may be removed.

In the etching process, the recess for the extension pattern may be stably formed in the first base portion 921b using the etch stopping layer 92c. In the process of forming or filling the warpage inducing material in the recess for the extension pattern, the warpage inducing material may be formed on the first base portion 921b to fill the recess for the extension pattern, and a portion of the warpage inducing material on the first base portion 921b may be removed. For example, the process of forming or filling the warpage inducing material may be performed by a deposition process or so on, and the process of removing the portion of the warpage inducing material on the first base portion 921b may be performed by a mechanical chemical polishing process or so on.

Between the process of forming the recess for the extension pattern and the process of forming the warpage inducing material, a process of removing the first mask layer 32 may be performed. For example, the first mask layer 32 may be removed using an etching process, an ashing process, a strip process, or so on. However, example embodiments are not limited thereto. In some example embodiments, the first mask layer 32 may be removed in the mechanical chemical polishing process of removing the portion of the warpage inducing material on the first base portion 921b. Various modifications are possible.

Subsequently, as illustrated in FIG. 12, a second base portion 922b of the base layer 92b and a bonding insulation layer 92a may be formed on the extension pattern 98 and the first base portion 921b. The second base portion 922b and the bonding insulation layer 92a may be formed by any of various processes (e.g., a deposition process).

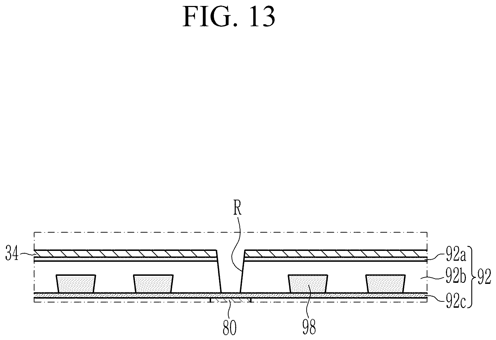

Subsequently, as illustrated in FIG. 13 to FIG. 17, a bonding structure 94 may be formed using a dual damascene process.

More particularly, as illustrated in FIG. 13, a recess R for a contact via may be formed in the base layer 92b and the bonding insulation layer 92a using a second mask layer 34.

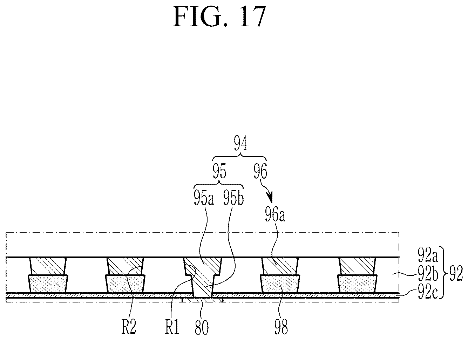

For example, the second mask layer 34 that exposes a portion where a contact via 95b (refer to FIG. 17) will be disposed may be formed on the insulation layer 92, and the recess R may be formed in the bonding insulation layer 92a and the base layer 92b by an etching process using the second mask layer 34. In the etching process, the recess R may be stably formed using the etch stopping layer 92c. The second mask layer 34 may be formed by a photo lithography process. After the recess R is formed, the first mask layer 34 may be removed using any of various processes (e.g., an etching process, an ashing process, a strip process, or so on).

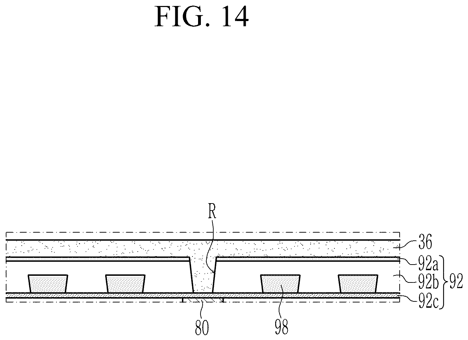

Subsequently, as illustrated in FIG. 14, a third mask layer 36 may be formed entirely on the insulation layer 92 to fill the recess R. The third mask layer 36 may be formed by any of various processes (e.g., a deposition process or so on).

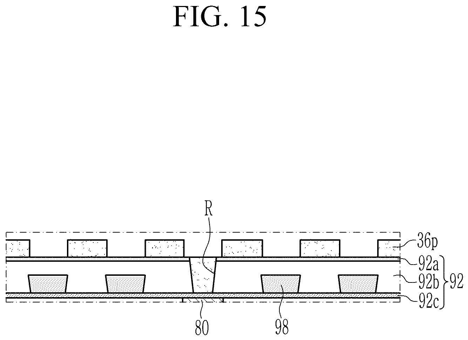

Subsequently, as illustrated in FIG. 15, portions of the third mask layer 36 (refer to FIG. 14) where a pad 95a (refer to FIG. 17) and a dummy pad 96a (refer to FIG. 17) will be disposed may be removed to form the mask pattern 36p. The portions of the third mask layer 36 may be removed by an etching process using a fourth mask layer. The fourth mask layer may be formed by a photolithography process, and may be removed by any of various processes (e.g., an etching process, an ashing process, a strip process, or so on) after a patterning process of the mask pattern 36p.

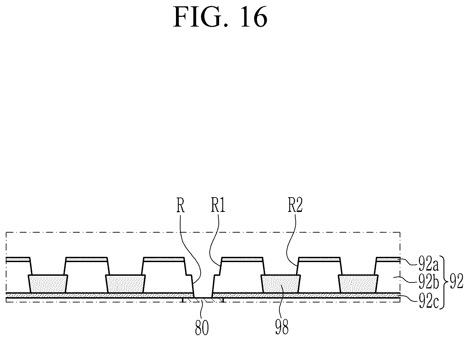

Subsequently, as illustrated in FIG. 16, a the first recess R1 and a second recess R2 may be formed by an etching process using the mask pattern 36p (refer to FIG. 15).

For example, in the insulation layer 92, a recess may be formed in a portion where the pad 95a (refer to FIG. 17) will be disposed and the second recess R2 may be formed in a portion where the dummy pad 96a (refer to FIG. 17) will be disposed. A portion of the mask pattern 36p in the recess R for the contact via may be removed using a process (e.g., an etching process, an ashing process, or so on) capable of selectively removing the mask pattern 36b, and a portion of the etch stopping layer 92c that is exposed by the recess R may be removed. Thereby, the first recess R1 may be formed to the portion where the pad structure 95 (refer to FIG. 17) will be disposed.

Subsequently, as illustrated in FIG. 17, a metal material may be formed or filled in the first recess R1 (refer to FIG. 16) and the second recess R2 (refer to FIG. 16) to form a bonding structure 94. In the process forming or filling the metal material in the first recess R1 and the second recess R2, the metal material may be formed in the first recess R1 and the second recess R2 and on the insulation layer 92, and then, a portion of the metal material on the insulation layer 92 may be removed. For example, the process forming or filling the metal material may be performed by a deposition process or so on, and the process of removing the portion of the metal material on the insulation layer 92 may be performed by a mechanical chemical polishing process or so on.

Accordingly, the extension pattern 98, and the bonding portion 90 including the bonding structure 94 formed by the dual damascene process may be formed by an easy process.

According to an example embodiment, by the extension pattern 98 disposed at a lower portion of the dummy structure 96, a warpage that may occur in the bonding semiconductor device 10 may be reduced or compensated for and an etching process may be controlled in a process of forming the dummy structure 96. The extension pattern 98 may be formed by an easy manufacturing process. The extension pattern 98 may be disposed at an empty space at the lower portion of the dummy structure 96 and thus may be applied to the bonding semiconductor device 10 without an additional space. By adjusting a material, a volume, a width, a thickness, a shape, a position, an arrangement, or so on of the extension pattern 98, the warpage of the bonding semiconductor device 10 may be effectively reduced and/or be precisely controlled. Thereby, reliability and/or productivity of the bonding semiconductor device 10 may be enhanced.

In a comparative example embodiment that does not include the extension pattern 98 that serves as the etch stopping pattern, an etching process of forming a recess for a dummy pad may be difficult to control and thus the etching process may be complicated. In another comparative example embodiment in which a dummy wiring is included instead of a dummy pad to reduce a warpage of a bonding semiconductor device, a metal material might not be sufficiently filled in a recess for a dummy wiring and thus it may act as a step in a subsequent process. Further, because a depth of the recess for the dummy wiring is relatively large, the dummy wiring may be undesirably connected to a wiring portion. To reduce or prevent this issue, a thickness of an insulation layer may be desired to be increased. Further, because a material of the dummy wiring is the same as a material of the pad, it is difficult to induce a desired stress in a bonding semiconductor device and the effect of reducing or compensating for the warpage of the bonding semiconductor device might not be sufficient. For example, when the dummy wiring includes copper, the stress is not large and thus it may be difficult to reduce or compensate for the warpage of the bonding semiconductor device.

In the above, it is described as an example that the extension pattern 98 of an extended shape is disposed at lower portions of at least two dummy structures 96. However, example embodiments are not limited thereto. In some example embodiments, a warpage reducing pattern, a warpage preventing pattern, a warpage inducing pattern, a skew reducing pattern, a skew preventing pattern, an etch stopping pattern, a multi-functional pattern that performs various functions, an intercalated pattern, or so on may be disposed at a lower portion of at least one dummy structure 96. The warpage inducing pattern may induce a warpage in a direction that is opposite to a direction of a warpage of the cell region 100 and/or the circuit region 200.

In the above, it is described as an example that a bonding semiconductor device 10 is a bonding vertical NAND flash memory, but example embodiments are not limited thereto. The bonding semiconductor device 10 may be any of various bonding semiconductor devices that has an empty space in a bonding portion 90 and desires a reduced warpage. For example, the bonding semiconductor device 10 may be or include any of various semiconductor devices, semiconductor apparatuses, or semiconductor packages that is formed by bonding a first region (a first chip) and a second region (a second chip). For example, the bonding semiconductor device 10 may be or include a memory semiconductor device, a logic semiconductor device, an image sensor, or so on. In some example embodiments, the bonding semiconductor device 10 may be or include a DRAM, an SRAM, an EEPROM, a PRAM, an MRAM, a high bandwidth memory (HBM), a microprocessor, or so on. Various modifications are possible.

Hereinafter, referring to FIG. 18 to FIG. 27, bonding semiconductor devices according to some example embodiments will be described in detail. To the extent that an element is not described in detail below, it may be understood that the element is at least substantially similar to (and/or the same as) a corresponding element that has been described elsewhere within the present disclosure. A portion which is not described in the above will be described in detail. The following description of a bonding portion 90 may be applied to a first bonding portion included in a cell region, and/or may be applied to a second bonding portion included in a circuit region.

FIG. 18 is a cross-sectional view that illustrates a partial portion of a bonding semiconductor device according to an example embodiment. FIG. 18 illustrates a portion corresponding to FIG. 5.

Referring to FIG. 18, in a bonding semiconductor device according to an example embodiment, an extension pattern 98 may include a first extension pattern 198 that is included in a cell region, and might not include a second extension pattern 298 (refer to FIG. 5) that is included in a circuit region. When the cell region may be a warpage region that has a relatively large warpage, the first extension pattern 198 is included in the cell region and the warpage of the cell region may be effectively controlled.. The circuit region may be an opposite region that has a relatively small warpage, and thus, the circuit region might not include the second extension pattern 298.

However, example embodiments are not limited thereto. When the circuit region is the warpage region and the cell region is an opposite region to the circuit region or when each of the circuit region and the cell region is the warpage region, the first extension pattern 198 may be included without the second extension pattern 298.

FIG. 19 is a cross-sectional view that illustrates a partial portion of a bonding semiconductor device according to an example embodiment. FIG. 19 illustrates a portion corresponding to FIG. 5.

Referring to FIG. 19, in a bonding semiconductor device according to an example embodiment, an extension pattern 98 may include a second extension pattern 298 that is included in a circuit region, and might not include a first extension pattern 198 (refer to FIG. 5) that is included in a cell region. Because the circuit region may be formed by an easy process than the cell region, the circuit region may include the second extension pattern 298 and thus a warpage of the cell region may be reduced or compensated for without increasing a process of the cell region.

However, example embodiments are not limited thereto. When the circuit region is the warpage region and the cell region is an opposite region to the circuit region or when each of the circuit region and the cell region is the warpage region, the second extension pattern 298 may be included without the first extension pattern.

FIG. 20 is a plan view that illustrates a partial portion of a bonding semiconductor device according to an example embodiment. FIG. 20 illustrates a portion corresponding to a partial portion of FIG. 7 or FIG. 8.

Referring to FIG. 20, an extension pattern 98 or an extension portion included in the same may be disposed to correspond a plurality of dummy structures 96 in a second direction (a Y-axis direction in the drawings). The extension pattern 98 or the extension portion may have a relatively large width, and thus, a stress by the extension pattern 98 or the extension portion may be large and a warpage of a bonding semiconductor device may be effectively reduced or compensated for.

In FIG. 7 and FIG. 20, it is illustrated as an example that each of a plurality of extension patterns 98 or a plurality of extension portions have the same or substantially similar width in the second direction. However, example embodiments are not limited thereto. As illustrated in FIG. 21, a plurality of extension patterns 98 or a plurality of extension portions having different widths may be included. By forming the plurality of extension patterns 98 or the plurality of extension portions having different widths considering a stress applied to the bonding semiconductor device or a warpage of the bonding semiconductor device, the warpage of the bonding semiconductor device may be effectively reduced and/or be precisely controlled.

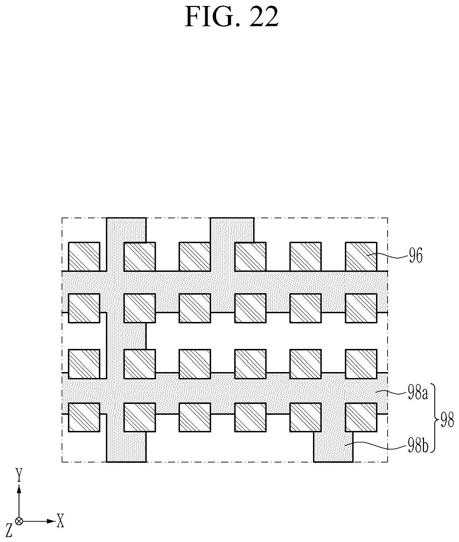

FIG. 22 is a plan view that illustrates a partial portion of a bonding semiconductor device according to an example embodiment. FIG. 22 illustrates a portion corresponding to a partial portion of FIG. 7 or FIG. 8.

Referring to FIG. 22, an extension pattern 98 may include a first extension portion 98a and a second extension portion 98b. The first extension portion 98a may extend in a first direction (an X-axis direction in the drawings), and the second extension portion 98b may extend in a second direction (a Y-axis direction in the drawings) that is transverse to or crosses (e.g., is perpendicular to) the first direction.

In FIG. 22, it is illustrated as an example that the extension pattern 98 includes a plurality of first extension portions 98a longitudinally extend in the first direction to have a regular interval and a plurality of second extension portions 98b extend in the second direction to have different intervals or to be partially disposed. The first extension portions 98a may be continuously and regularly disposed considering a stress due to gate electrodes, and the second extension portions 98b may be locally and partially disposed considering another stress other than the stress due to the gate electrodes. Accordingly, a warpage of a bonding semiconductor device may be effectively reduced and/or be precisely controlled. However, example embodiments are not limited thereto. In some example embodiment, the first extension portions 98a may be locally and partially disposed, and/or the second extension portions 98b may be continuously and regularly disposed.

In an example embodiment, at least one dummy structure 96 or a partial portion of the dummy structure 96 may be disposed on the extension pattern 98, and another dummy structure 96 or another portion of the dummy structure 96 might not be disposed on the extension pattern 98. However, example embodiments are not limited thereto, and an entire portion of the dummy structure 96 may be disposed on the extension pattern 98.

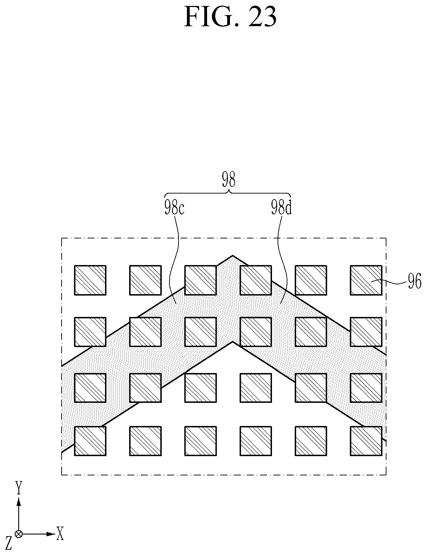

FIG. 23 is a plan view that illustrates a partial portion of a bonding semiconductor device according to an example embodiment. FIG. 23 illustrates a portion corresponding to a partial portion of FIG. 7 or FIG. 8.

Referring to FIG. 23, an extension pattern 98 may include a third extension portion 98c and a fourth extension portion 98d. The third extension portion 98c may extend in a third direction (e.g., a first diagonal direction) that is transverse to, crosses, or is inclined to a first direction (an X-axis direction in the drawings) and a second direction (a Y-axis direction in the drawings). The fourth extension portion 98d may extend in a fourth direction (e.g., a second diagonal direction) that is transverse to, crosses, or is inclined to the first direction and the second direction and is transverse to or crosses the third direction. In a case that the third extension portion 98c and/or the fourth extension portion 98d is needed or desired considering a stress applied to the bonding semiconductor device or a warpage of the bonding semiconductor device, the third extension portion 98c and/or the fourth extension portion 98d may be included.

In FIG. 23, it is illustrated as an example that the extension pattern 98 includes the third extension portion 98c and the fourth extension portion 98d to have a zigzag shape. In some example embodiments, the extension pattern 98 may include one of the third extension portion 98c and the fourth extension portion 98d. The extension pattern 98 may further include at least one of a first extension portion that extends in the first direction or a second extension portion that extends in the second direction.

In an example embodiment, at least one dummy structure 96 or a partial portion of the dummy structure 96 may be disposed on the extension pattern 98, and another dummy structure 96 or another portion of the dummy structure 96 might not be disposed on the extension pattern 98.

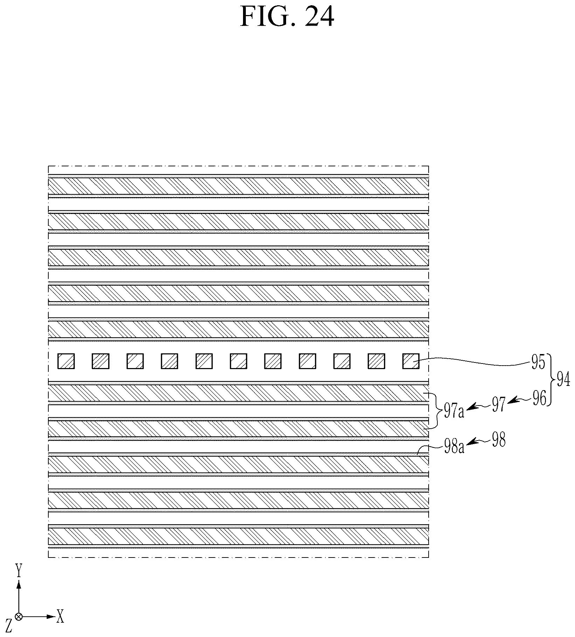

FIG. 24 is a plan view that illustrates a partial portion of a bonding semiconductor device according to an example embodiment. FIG. 24 illustrates a portion corresponding to a partial portion of FIG. 7 or FIG. 8.

Referring to FIG. 24, in a bonding semiconductor device according to an example embodiment, a bonding structure 94 may include a pad structure 95 and a dummy structure 96 that includes a dummy wiring 97.

The dummy wiring 97 may have a cross-sectional shape that is the same as or similar to a cross-sectional shape of a dummy structure described with reference to FIG. 1 to FIG. 23, but may have a planar shape that is different from a planar shape of the dummy structure described with reference to FIG. 1 to FIG. 23.

The dummy wiring 97 may pass through a partial portion of an insulation layer (e.g., a first insulation layer or a second insulation layer) included in a bonding portion. A first surface of the dummy wiring 97 may be adjacent to a bonding surface, and a second surface of the dummy wiring 97 that is opposite to the first surface of the dummy wiring 97 may be spaced apart from a wiring portion or an adjacent surface that is adjacent to a wiring portion. The dummy wiring 97 might not include a portion corresponding to a contact via of the pad structure 95. The dummy wiring 97 may be a portion that does not contribute to an electrical connection between a circuit region and a cell region. In a plan view, the dummy wiring 97 may include a first dummy wiring 97a that extends in one direction.

By the first dummy wiring 97a of the dummy wiring 97, a warpage of the bonding semiconductor device may be reduced or compensated for. The dummy wiring 97 may assist the extension pattern 98 and thus the effect of reducing or compensating for the warpage of the bonding semiconductor device may be enhanced.

The extension pattern 98 may pass through a partial portion of the insulation layer, may be disposed between the dummy structure 96 (e.g., the dummy wiring 97) and the wiring portion at a lower portion of the dummy structure 96. In a plan view, the extension pattern 98 may include a first extension portion 98a that extends in one direction (e.g., a direction parallel to the first dummy wiring 97a). At least a partial portion of the first dummy wiring 97a may be disposed on the first extension portion 98a.

In an example embodiment, a width of at least a partial portion of the first extension portion 98a may be greater than a width of the first dummy wiring 97a. The width of the dummy wiring 97 may be a width in a direction that is transverse to or crosses (e.g., is perpendicular to) the dummy wiring 97 or be a minimum width. For example, in a cross-sectional view that crosses (e.g. perpendicular to) an extension direction of the first extension portion 98a, the width of the first extension portion 98a may be greater than the width of the first dummy wiring 97a.

An entire portion of at least one dummy wiring 97 may be disposed on the extension pattern 98. Thereby, in a process of forming the dummy wiring 97, the extension pattern 98 may stably act as an etch stopping pattern. Thereby, the extension pattern 98 may have a sufficient planar area, and thus, the extension pattern 98 may stably act as the warpage reducing pattern.

However, example embodiments are not limited thereto. In some example embodiments, the width of at least a partial portion of the extension pattern 98 may be the same as or smaller than the width of the dummy structure 96. In some example embodiments, at least one dummy wiring 97 or a partial portion of the dummy wiring 97 may be disposed on the extension pattern 98, and another dummy structure 96 or another portion of the dummy structure 96 might not be disposed on the extension pattern 98. Various modifications are possible.

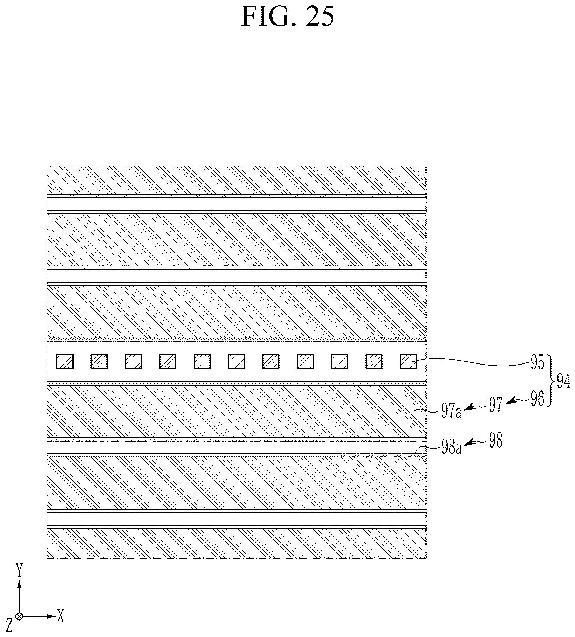

In FIG. 24, it is illustrated as an example that the width of the dummy wiring 97 may be the same as or substantially similar to the width of the pad structure 95 in a direction that is transverse to or crosses (e.g., is perpendicular to) the extension direction of the dummy wiring 97. Substantially the same may refer to have a difference of less than 10%. However, example embodiments are not limited thereto. In some example embodiment, as illustrated in FIG. 25, a width of the dummy wiring 97 may be greater than a width of the pad structure 95 in a direction that is transverse to or crosses (e.g., is perpendicular to) an extension direction of the dummy wiring 97. When the dummy wiring 97 and/or the extension pattern 98 may have a relatively large width, a stress inducing a warpage may be increased and a warpage of the bonding semiconductor device may be effectively reduced or compensated for.

In FIG. 24 and FIG. 25, it is illustrated as an example that a plurality of dummy wirings 97 and/or a plurality of extension patterns 98 have the same or substantially similar width. However, example embodiments are not limited thereto. In some example embodiments, the plurality of dummy wirings 97 and/or a plurality of extension pattern 98 having different widths may be included. By forming the plurality of dummy wirings 97 and/or the plurality of extension patterns 98 having different widths in consideration of a stress applied to the bonding semiconductor device or a warpage of the bonding semiconductor device, the warpage of the bonding semiconductor device may be effectively reduced and/or be precisely controlled.

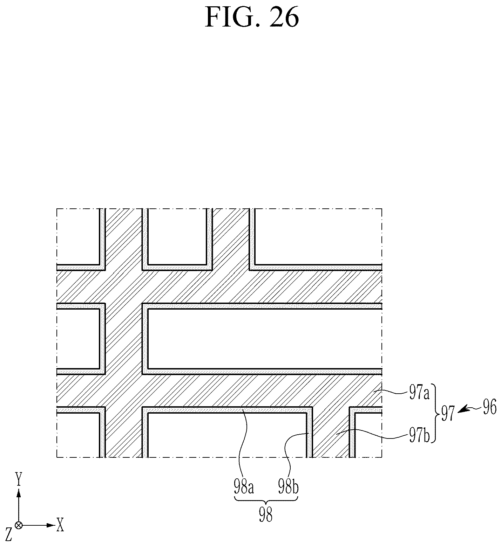

FIG. 26 is a plan view that illustrates a partial portion of a bonding semiconductor device according to an example embodiment. FIG. 26 illustrates a portion corresponding to a partial portion of FIG. 24.

Referring to FIG. 26, in a bonding semiconductor device according to an example embodiment, a bonding structure 94 may include a pad structure 95 and a dummy structure 96 that includes a dummy wiring 97. The dummy wiring 97 may include a first dummy wiring 97a and a second dummy wiring 97b. The first dummy wiring 97a may extend in a first direction (an X-axis direction in the drawings), and the second dummy wiring 97b may extend in a second direction (a Y-axis direction in the drawings).

In FIG. 26, it is illustrated as an example that the dummy wiring 97 includes a plurality of first dummy wirings 97a longitudinally extend in the first direction to have a regular interval and a plurality of second dummy wirings 97b extend in the second direction to have different intervals or to be partially disposed. The first dummy wirings 97a may be continuously and regularly disposed considering a stress due to gate electrodes, and the second dummy wirings 97b may be locally and partially disposed considering another stress other than the stress due to the gate electrodes. Accordingly, a warpage of a bonding semiconductor device may be effectively reduced and/or be precisely controlled. However, example embodiments are not limited thereto. In some example embodiment, the first dummy wirings 97a may be locally and partially disposed, and/or the second dummy wirings 97b may be continuously and regularly disposed.

In a plan view, an extension pattern 98 may include a first extension portion 98a and a second extension portion 98b. The first extension portion 98a may extend in a first direction, and the second extension portion 98b may extend in a second direction. At least a partial portion of the first dummy wiring 97a may be disposed on the first extension portion 98a, and at least a partial portion of the second dummy wiring 97b may be disposed on the second extension portion 98b.

In an example embodiment, a width of at least a partial portion of the first extension portion 98a may be greater than a width of the first dummy wiring 97a, and a width of at least a partial portion of the second extension portion 98b may be greater than a width of the second dummy wiring 97b. For example, in a cross-sectional view that crosses (e.g. perpendicular to) an extension direction of the first extension portion 98a, the width of the first extension portion 98a may be greater than the width of the first dummy wiring 97a. For example, in a cross-sectional view that crosses (e.g. perpendicular to) an extension direction of the second extension portion 98b, the width of the second extension portion 98b may be greater than the width of the second dummy wiring 97b.

An entire portion of at least one dummy wiring 97 may be disposed on the extension pattern 98. Thereby, in a process of forming the dummy wiring 97, the extension pattern 98 may stably act as an etch stopping pattern. Further, the extension pattern 98 may have a sufficient planar area, and thus, the extension pattern 98 may stably act as the warpage reducing pattern.

However, example embodiments are not limited thereto. In some example embodiments, the width of at least a partial portion of the extension pattern 98 may be the same as or smaller than the width of the dummy structure 96. In some example embodiments, at least one dummy wiring 97 or a partial portion of the dummy wiring 97 may be disposed on the extension pattern 98, and another dummy structure 96 or another portion of the dummy structure 96 might not be disposed on the extension pattern 98. Various modifications are possible.

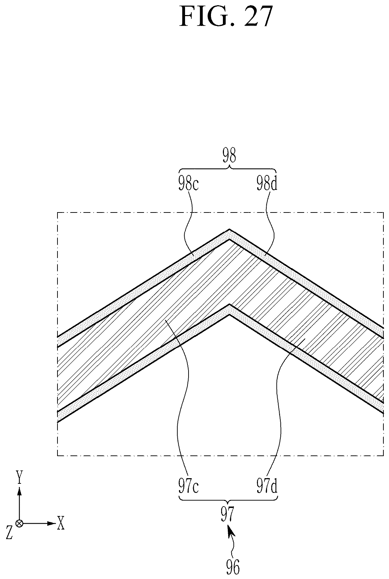

FIG. 27 is a plan view that illustrates a partial portion of a bonding semiconductor device according to an example embodiment. FIG. 27 illustrates a portion corresponding to a partial portion of FIG. 24.

Referring to FIG. 27, in a bonding semiconductor device according to an example embodiment, a bonding structure 94 may include a pad structure 95 and a dummy structure 96 that includes a dummy wiring 97. The dummy wiring 97 may include a third dummy wiring 97c and a fourth dummy wiring 97d. The third dummy wiring 97c may extend in a third direction (e.g., a first diagonal direction) that is transverse to, crosses, or is inclined to a first direction (an X-axis direction in the drawings) and a second direction (a Y-axis direction in the drawings). The fourth dummy wiring 97d may extend in a fourth direction (e.g., a second diagonal direction) that is transverse to, crosses, or is inclined to the first direction and the second direction and is transverse to or crosses the third direction. In a case that the third dummy wiring 97c and/or the fourth dummy wiring 97d is needed or desired considering a stress applied to the bonding semiconductor device or a warpage of the bonding semiconductor device, the third dummy wiring 97c and/or the fourth dummy wiring 97d may be included.

In FIG. 27, it is illustrated as an example that the dummy wiring 97 includes the third dummy wiring 97c and the fourth dummy wiring 97d to have a zigzag shape. In some example embodiments, the dummy wiring 97 may include one of the third dummy wiring 97c and the fourth dummy wiring 97d. The dummy wiring 97 may further include at least one of a first dummy wiring that extends in the first direction or a second dummy wiring that extends in the second direction.

In a plan view, an extension pattern 98 may include a third extension portion 98c and a fourth extension portion 98d. The third extension portion 98c may extend in the third direction, and the fourth extension portion 98d may extend in a fourth direction. At least a partial portion of the third dummy wiring 97c may be disposed on the third extension portion 98c, and at least a partial portion of the fourth dummy wiring 97d may be disposed on the fourth extension portion 98d.

In an example embodiment, a width of at least a partial portion of the third extension portion 98c may be greater than a width of the third dummy wiring 97c, and a width of at least a partial portion of the fourth extension portion 98d may be greater than a width of the fourth dummy wiring 97d. For example, in a cross-sectional view that crosses (e.g. perpendicular to) an extension direction of the third extension portion 98c, the width of the third extension portion 98c may be greater than the width of the third dummy wiring 97c. For example, in a cross-sectional view that crosses (e.g. perpendicular to) an extension direction of the fourth extension portion 98d, the width of the fourth extension portion 98d may be greater than the width of the fourth dummy wiring 97d.

An entire portion of at least one dummy wiring 97 may be disposed on the extension pattern 98. Thereby, in a process of forming the dummy wiring 97, the extension pattern 98 may stably act as an etch stopping pattern. Thereby, the extension pattern 98 may have a sufficient planar area, and thus, the extension pattern 98 may stably act as the warpage reducing pattern.

However, example embodiments are not limited thereto. In some example embodiments, the width of at least a partial portion of the extension pattern 98 may be the same as or smaller than the width of the dummy structure 96. In some example embodiments, at least one dummy wiring 97 or a partial portion of the dummy wiring 97 may be disposed on the extension pattern 98, and another dummy structure 96 or another portion of the dummy structure 96 might not be disposed on the extension pattern 98. Various modifications are possible.

As illustrated in FIG. 1 to FIG. 27, a position, a shape, an arrangement, or so on of the extension pattern 98 and/or the dummy wiring 97 may be variously modified. Thereby, a stress applied to the bonding semiconductor device or a warpage of the bonding semiconductor device may be effectively reduced and/or be precisely controlled. Considering the stress applied to the bonding semiconductor device or the warpage of the bonding semiconductor device, the extension patterns 98 and/or the dummy wirings 97 according to the example embodiments described with reference to FIG. 1 to FIG. 27 may be combined with each other.

Hereinafter, an example of an electronic system that includes a semiconductor device described in the above will be described in detail.

FIG. 28 schematically illustrates an electronic system that includes a semiconductor device according to an example embodiment.

Referring to FIG. 28, an electronic system 1000 according to an example embodiment may include a semiconductor device 1100 and a controller 1200 that is electrically connected to the semiconductor device 1100. The electronic system 1000 may be a storage device that includes one or a plurality of semiconductor devices 1100 or an electronic device that includes the storage device. For example, the electronic system 1000 may be a solid-state drive (SSD) device, a universal serial bus (USB), a computing system, a medical device, or a communication device that includes one or a plurality of semiconductor devices 1100.

The semiconductor device 1100 may be a non-volatile memory device, and for example, may be a NAND flash memory device described with reference to FIG. 1 to FIG. 27. The semiconductor device 1100 may include a first structure 1100F and a second structure 1100S that is disposed on the first structure 1100F. The first structure 1100F may be a peripheral circuit structure that includes a decoder circuit 1110, a page buffer 1120, and a logic circuit 1130. The second structure 1100S may be a memory cell structure that includes a bit line BL, a common source line CSL, a word line WL, first and second gate upper lines UL1 and UL2, first and second gate lower lines LL1 and LL2, and a memory cell string CSTR between the bit line BL and the common source line CSL.

In the second structure 1100S, each of memory cell strings CSTR may include lower transistors LT1 and LT2 that are adjacent to the common source line CSL, upper transistors UT1 and UT2 that are adjacent to the bit line BL, and a plurality of memory cell transistors MCT between the lower transistors LT1 and LT2 and the upper transistors UT1 and UT2. A number of the lower transistors LT1 and LT2 and a number of the upper transistors UT1 and UT2 may be variously modified according to an example embodiment.

In an example embodiment, the lower transistor LT1 or LT2 may include a ground selection transistor, and the upper transistor UT1 or UT2 may include a string selection transistor. The first and second gate lower lines LL1 and LL2 may be gate electrodes of the lower transistors LT1 and LT2, respectively. The word line WL may be a gate electrode of the memory cell transistor MCT, and the gate upper lines UL1 and UL2 may be gate electrodes of the upper transistors UT1 and UT2, respectively.

The common source line CSL, the first and second gate lower lines LL1 and LL2, the word line WL, and the first and second gate upper lines UL1 and UL2 may be electrically connected to the decoder circuit 1110 through a first connection wiring 1115 that extends to the second structure 1100S within the first structure 1100F. The bit line BL may be electrically connected to the page buffer 1120 through a second connection wiring 1125 that extends to the second structure 1100S within the first structure 1100F.

In the first structure 1100F, the decoder circuit 1110 and the page buffer 1120 may execute a control operation for at least one memory cell transistor selected from the plurality of memory cell transistors MCT. The decoder circuit 1110 and the page buffer 1120 may be controlled by the logic circuit 1130. The semiconductor device 1100 may communicate with the controller 1200 through an input/output pad 1101 that is electrically connected to the logic circuit 1130. The input/output pad 1101 may be electrically connected to the logic circuit 1130 through an input/output connection wiring 1135 that extends to the second structure 1100S within the first structure 1100F.

The controller 1200 may include a processor 1210, a NAND controller 1220, and a host interface 1230. In some example embodiments, the electronic system 1000 may include a plurality of semiconductor devices 1100, and in this case, the controller 1200 may control the plurality of semiconductor devices 1100.

The processor 1210 may control an overall operation of the electronic system 1000 including the controller 1200. The processor 1210 may operate according to predetermined firmware, and may access the semiconductor device 1100 by controlling the NAND controller 1220. The NAND controller 1220 may include a NAND interface 1221 that processes communication with the semiconductor device 1100. A control command for controlling the semiconductor device 1100, data to be written in the memory cell transistor MCT of the semiconductor device 1100, and data to be read from the memory cell transistor MCT of the semiconductor device 1100, or so on may be transmitted through the NAND interface 1221. The host interface 1230 may provide a communication function between the electronic system 1000 and an external host. When a control command is received from the external host through the host interface 1230, the processor 1210 may control the semiconductor device 1100 in response to the control command.

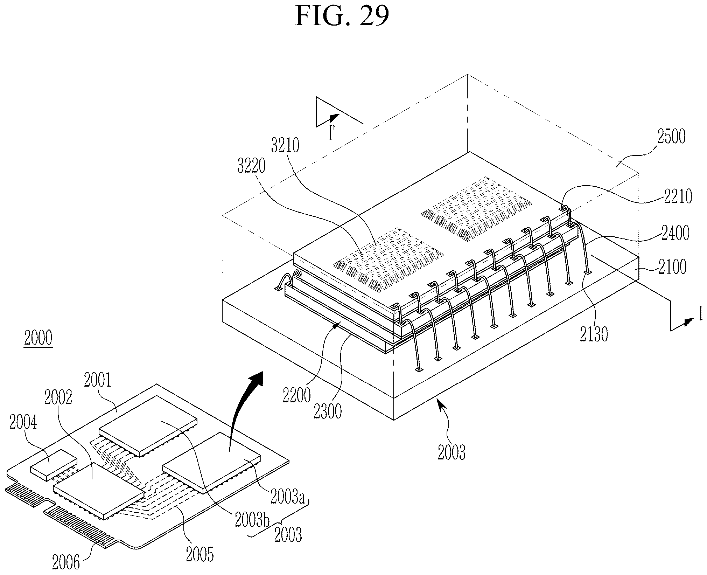

FIG. 29 is a perspective view that schematically illustrates an electronic system including a semiconductor device according to an example embodiment.

Referring to FIG. 29, an electronic system 2000 according to an example embodiment may include a main substrate 2001, a controller 2002 that is mounted on the main substrate 2001, one or more semiconductor packages 2003, and a DRAM 2004. The semiconductor package 2003 and the DRAM 2004 may be connected to the controller 2002 through a wiring pattern 2005 that is provided on the main substrate 2001.

The main substrate 2001 may include a connector 2006 that includes a plurality of pins coupled to the external host. A number and an arrangement of the plurality of pins in the connector 2006 may vary depending on a communication interface between the electronic system 2000 and the external host. In an example embodiment, the electronic system 2000 may communicate with the external host according to any one of interfaces such as a universal serial bus (USB), a peripheral component interconnect express (PCI-Express), a serial advanced technology attachment (SATA), or an M-Phy for a universal flash storage (UFS). In an example embodiment, the electronic system 2000 may operate by power that is supplied from the external host through the connector 2006. The electronic system 2000 may further include a power management integrated circuit (PMIC) that distributes the power supplied from the external host to the controller 2002 and the semiconductor package 2003.

The controller 2002 may write data in the semiconductor package 2003 or may read data from the semiconductor package 2003, and may improve an operating speed of the electronic system 2000.

The DRAM 2004 may be a buffer memory for mitigating or buffering a speed difference between the semiconductor package 2003, which is a data storage space, and the external host. The DRAM 2004 that is included in the electronic system 2000 may also be a kind of cache memory, and may also provide a space for temporarily storing data in a control operation for the semiconductor package 2003. When the electronic system 2000 includes the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b that are spaced apart from each other. Each of the first and second semiconductor packages 2003a and 2003b may be a semiconductor package that includes a plurality of semiconductor chips 2200. Each of the first and second semiconductor packages 2003a and 2003b may include a package substrate 2100, the semiconductor chip 2200 that is disposed on the package substrate 2100, an adhesive layer 2300 at a lower surface of each semiconductor chip 2200, a connection structure 2400 that electrically connects the semiconductor chip 2200 and the package substrate 2100, and a molding layer 2500 that covers the semiconductor chip 2200 and the connection structure 2400 on the package substrate 2100.

The package substrate 2100 may be a printed circuit board that includes a package upper pad 2130. Each semiconductor chip 2200 may include an input/output pad 2210. The input/output pad 2210 may correspond to an input/output pad 1101 of FIG. 28. Each semiconductor chip 2200 may include a gate stacking structure 3210 and a channel structure 3220. The semiconductor chip 2200 may include the semiconductor device described with reference to FIG. 1 to FIG. 27.

In an example embodiment, the connection structure 2400 may be a bonding wire that electrically connects the input/output pad 2210 and the package upper pad 2130. Accordingly, in each of the first and second semiconductor packages 2003a and 2003b, the semiconductor chips 2200 may be electrically connected to each other using a bonding wire type, and the semiconductor chip 2200 may be electrically connected to the package upper pad 2130 of the package substrate 2100. According to an example embodiment, in each of the first and second semiconductor packages 2003a and 2003b, the semiconductor chips 2200 may be electrically connected to each other by a connection structure that includes a through silicon via (TSV) instead of the connection structure 2400 of the bonding wire type.

In an example embodiment, the controller 2002 and the semiconductor chip 2200 may be included in one package. For example, the controller 2002 and the semiconductor chip 2200 may be mounted on a separate interposer substrate that is different from the main substrate 2001, and the controller 2002 and the semiconductor chip 2200 may be connected to each other by a wiring of the interposer substrate.

FIG. 30 is a cross-sectional view that schematically illustrates a semiconductor package according to an example embodiment. FIG. 30 illustrates an example embodiment of the semiconductor package 2003 of FIG. 29, and conceptually illustrates a region of the semiconductor package 2003 taken along a line I-I' in FIG. 29.

Referring to FIG. 30, in a semiconductor package 2003, a package substrate 2100 may be a printed circuit board. The package substrate 2100 may include a package substrate body portion 2120, a package upper pad 2130 that is disposed at an upper surface of the package substrate body portion 2120, a package lower pad 2125 that is disposed at a lower surface of the package substrate body portion 2120 or is exposed through the lower surface of the package substrate body portion 2120, and an internal wiring 2135 that electrically connects the package upper pad 2130 and the package lower pad 2125 inside the package substrate body portion 2120. The package upper pad 2130 may be electrically connected to the connection structure 2400. The package lower pad 2125 may be connected to a wiring pattern 2005 of a main substrate 2001 of an electronic system 2000, as illustrated in FIG. 29, through a conductive connection portion 2800.

In a semiconductor package 2003, each semiconductor chip 2200 may include a semiconductor substrate 4010, a first structure 4100 that is disposed on the semiconductor substrate 4010, and a second structure 4200 that is disposed on the first structure 4100 and is bonded to the first structure 4100 by a wafer bonding type.

The first structure 4100 may include a peripheral circuit region that includes a peripheral wiring 4110 and a first bonding structure 4150. The second structure 4200 may include a common source line 4205, a gate stacking structure 4210 between the common source line 4205 and the first structure 4100, a channel structure 4220 and a separation structure 4230 that pass through the gate stacking structure 4210, and a second bonding structures 4250 that are electrically connected to the channel structure 4220 and a word line WL (refer to FIG. 28) of the gate stacking structure 4210. For example, the second bonding structure 4250 may be electrically connected to the channel structure 4220 and the word line WL through a bit line 4240 that is electrically connected to the channel structure 4220 and a gate connection wiring that is electrically connected to the word line WL. The first bonding structure 4150 of the first structure 4100 and the second bonding structure 4250 of the second structure 4200 may be in contact with and bonded to each other. For example, portions of the first bonding structure 4150 and the second bonding structure 4250 where the first bonding structure 4150 and the second bonding structure 4250 are bonded may include copper (Cu).

According to an example embodiment, by an extension pattern disposed at a lower portion of a dummy structure, a warpage that may occur in a bonding semiconductor device may be reduced or compensated for and an etching process may be controlled in a process of forming the dummy structure. Thereby, reliability and/or productivity of a bonding semiconductor device may be enhanced.

Each of the semiconductor chips 2200 may further include an input/output pad 2210 and an input/output connection wiring 4265 that is disposed at a lower portion of the input/output pad 2210. The input/output connection wiring 4265 may be electrically connected to a part of the second bonding structures 4250.

In an example embodiment, in the semiconductor package 2003, a plurality of semiconductor chips 2200 may be electrically connected to each other by a connection structure 2400 having a bonding wire type. In some example embodiments, the plurality of semiconductor chips 2200 or a plurality of portions that constitute the plurality of semiconductor chips 2200 may be electrically connected by a connection structure that includes a through silicon via (TSV).

Any functional blocks shown in the figures and described above may be implemented in processing circuitry such as hardware including logic circuits, a hardware/software combination such as a processor executing software, or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

While some examples have been described in connection with what is presently considered to be some practical example embodiments, it is to be understood that the disclosure is not limited to the disclosed example embodiments, and that the disclosure is intended to cover various modifications and equivalent arrangements included within the scope of the appended claims.

## Claims

1. A semiconductor chip for a bonding semiconductor device, comprising:
a substrate (110, 210);
a wiring portion (180, 280) on the substrate (110, 210); and
a bonding portion (190, 290) on the wiring portion (180, 280),
wherein the bonding portion (190, 290) includes:
an insulation layer (192, 292);
a bonding structure (94, 194, 294) including a pad structure (95, 195, 295) and a dummy structure (96, 196, 296), the pad structure (95, 195, 295) passing through the insulation layer (92, 192, 292), the dummy structure (96, 196, 296) passing through a partial portion of the insulation layer (92, 192, 292); and
an extension pattern (98, 198, 298) at a lower portion of the dummy structure (196, 296), the lower portion of the dummy structure (96, 196, 296) being a portion adjacent to the wiring portion (180, 280), and the extension pattern (98, 198, 298) including an extension portion (98a, 198a) that extends in one direction in a plan view.

2. The semiconductor chip of claim 1, wherein
the pad structure (95, 195, 295) includes a pad (195a, 295a) and a contact via (195b, 295b), the pad (195a, 295a) being adjacent to a bonding surface (BS), the contact via (195b, 295b) connecting the pad (195a, 295a) and the wiring portion (180, 280), the bonding surface (BS) being opposite to the wiring portion (180, 280),
the dummy structure (96, 196, 296) includes a dummy pad (96a, 196a, 296a) or a dummy wiring (97) that is adjacent to the bonding surface (BS), and
the extension pattern (98, 198, 298) is between the dummy pad (96a, 196a, 296a) and the wiring portion (180, 280) or between the dummy wiring (97) and the wiring portion (180, 280).

3. The semiconductor chip of claim 1 or 2, wherein
the insulation layer (92, 192, 292) includes a bonding insulation layer (92a, 192a, 292a), an etch stopping layer (92c, 192c, 292c), and a base layer (92b, 192b, 292b), the bonding insulation layer (92a, 192a, 292a) being adjacent to a bonding surface (BS), the etch stopping layer (92c, 192c, 292c) being adjacent to the wiring portion (180, 280), the base layer (92b, 192b, 292b) being between the bonding insulation layer (92a, 192a, 292a) and the etch stopping layer (92c, 192c, 292c), the bonding surface (BS) being opposite to the wiring portion (180, 280), and
the extension pattern (98, 198, 298) passes through the base layer (92b, 192b, 292b) between the etch stopping layer (92c, 192c, 292c) and the dummy structure (96, 196, 296).

4. The semiconductor chip of any one of claims 1 to 3, wherein
the dummy structure (96, 196, 296) includes a plurality of dummy pads (96a, 196a, 296a), and
in a plan view, the extension pattern (98, 198, 298) or the extension portion (98a, 198a) extends to connect at least two dummy pads among the plurality of dummy pads (96a, 196a, 296a).

5. The semiconductor chip of any one of claims 1 to 4, wherein the extension portion (98a, 198a) includes a plurality of extension portions (98a, 198a) that extend in the one direction and are spaced apart from each other in another direction that crosses the one direction.

6. The semiconductor chip of any one of claims 1 to 5, wherein
in a plan view, the extension pattern (98, 198, 298) includes at least one of a first extension portion, a second extension portion, and a third extension portion, and
the first extension portion extends in a first direction, the second extension portion extends in a second direction that is perpendicular to the first direction, and the third extension portion extends in a third direction that is inclined with respect to the first direction and the second direction.

7. The semiconductor chip of any one of claims 1 to 6, wherein a width of at least a partial portion of the extension pattern (98, 198, 298) or the extension portion (98a, 198a) is greater than a width of the dummy structure (96, 196, 296).

8. The semiconductor chip of any one of claims 1 to 7, wherein the extension pattern (98, 198, 298) includes an insulating material that is a different from a material of at least a partial portion of the insulation layer (92, 192, 292) or has a composition different from a composition of at least a partial portion of the insulation layer (92, 192, 292).

9. The semiconductor chip of claim 8, wherein
the insulation layer (92, 192, 292) includes a bonding insulation layer (92a, 192a, 292a) and a base layer (92b, 192b, 292b), the bonding insulation layer (92a, 192a, 292a) being adjacent to a bonding surface (BS) that is opposite to the wiring portion (180, 280), the base layer (92b, 192b, 292b) being at a lower portion of the bonding insulation layer (92a, 192a, 292a) and having a thickness greater than a thickness of the bonding insulation layer (92a, 192a, 292a), the lower portion of the bonding insulation layer (92a, 192a, 292a) being a portion of the bonding insulation layer (92a, 192a, 292a) that is opposite to the bonding surface (BS), and
the extension pattern (98, 198, 298) includes a material that is different from a material of the base layer (92b, 192b, 292b) or has a composition that is different from a composition of the base layer (92b, 192b, 292b).

10. The semiconductor chip of any one of claims 1 to 9, wherein the extension pattern (98, 198, 298) includes at least one of oxide, nitride, carbonitride, oxycarbide, oxynitride, oxycarbonitride, or a resin.

11. A bonding semiconductor device, comprising:
a cell region (100) and a circuit region (200) that are bonded to each other, each of the cell region (100) and the circuit region (200) including a bonding portion (190, 290) that includes an insulation layer (192, 292) and a bonding structure (94, 194, 294), the bonding structure (94, 194, 294) including a pad structure (95, 195, 295) and a dummy structure (96, 196, 296), wherein
the cell region (100) and/or the circuit region (200) is a semiconductor chip according to any one of claims 1 to 10,
the cell region (100) includes a gate stacking structure (120) and a channel structure (CH),
the gate stacking structure (120) includes a plurality of interlayer insulation layers (132) and a plurality of gate electrodes (130) alternately stacked on each other and extends in a first direction,
the channel structure (CH) passes through the gate stacking structure (120), and
the bonding portion (190, 290) in at least one of the circuit region (200) or the cell region (100) includes an extension pattern (98, 198, 298), the extension pattern (98, 198, 298) being on a lower portion of the dummy structure (96, 196, 296) and including an extension portion (98a, 198a) that extends in the first direction.

12. The bonding semiconductor device of claim 11, wherein
the bonding portion (190, 290) of the cell region (100) includes the extension pattern (98, 198, 298), and the extension pattern (98, 198, 298) in the cell region (100) includes a material configured to induce a stress opposite to a stress due to the plurality of gate electrodes (130).

13. The bonding semiconductor device of claim 11, wherein
the bonding portion (190, 290) of the circuit region (200) includes the extension pattern (98, 198, 298), and the extension pattern (98, 198, 298) in the circuit region (200) includes a material configured to induce a stress same as a stress due to the plurality of gate electrodes (130).

14. The bonding semiconductor device of claim 11, wherein when a tensile stress is applied to the cell region (100) by the plurality of gate electrodes (130),
the extension pattern (98, 198, 298) includes at least one of a first extension pattern in the bonding portion (190, 290) of the cell region (100) or a second extension pattern in the bonding portion (190, 290) of the circuit region (200), and
the first extension pattern includes a compressive-stress material that induces a compressive stress and the second extension pattern includes a tensile-stress material that induces a tensile stress.

15. The bonding semiconductor device of any one of claims 11 to 14, wherein the bonding semiconductor device (10) includes a plurality of memory regions (10m) that are divided, partitioned, or defined by a partition portion (12), and the extension pattern (98, 198, 298) is in the partition portion (12), or
the cell region (100) includes a cell array region (102) and a connection region (104), and the extension pattern (98, 198, 298) is in the cell array region (102), the cell region (100) including the gate stacking structure (120) and the channel structure (CH), the connection region (104) where the plurality of gate electrodes (130) and a plurality of gate contact portions (184) are connected.
